# EUROPEAN PATENT SPECIFICATION

(11) **EP 1 953 257 B1**
(45) Date of publication and mention of the grant of the patent: **17.08.2011**
(21) Application number: 06811440.4
(22) Date of filing: 06.10.2006
(51) Int. Cl.: C23C 14/35

(54) **MAGNETRON SPUTTERING APPARATUS**
MAGNETRON-SPUTTERVORRICHTUNG
DISPOSITIF DE PULVÉRISATION CATHODIQUE DE MAGNÉTRON

(30) Priority: 07.10.2005 JP 2005295181
(43) Date of publication of application: 06.08.2008
(73) Proprietor: TOHOKU UNIVERSITY, Aoba-ku Sendai-shi, Miyagi 980-8577 (JP); Tokyo Electron Ltd., Tokyo 107-8481 (JP)
(72) Inventor: OHMI Tadahiro, Sendai-shi Miyagi 980-8577 (JP); GOTO Tetsuya, Sendai-shi Miyagi 980-8577 (JP); MATSUOKA Takaaki, Tokyo 107-8481 (JP)
(74) Representative: Glawe, Delfs, Moll
(86) International application number: PCT/JP2006/320113
(87) International publication number: WO 2007/043476

(56) References cited:
- GB-A- 2 393 321
- JP-A- 07 180 056
- JP-A- 10 026 698
- JP-A- 10 287 977
- JP-A- 59 116 375
- JP-A- 63 307 270
- JP-A- 2000 219 965
- JP-A- 2001 032 067
- JP-A- 2001 164 362
- US-A- 5 345 207
- US-A- 5 399 253
- US-B1- 6 351 075

## Description

### Technical Field

The present invention relates to a magnetron sputtering apparatus which serves as a processing device for performing predetermined surface processing on a processed member, such as a liquid crystal display substrate, semiconductor substrate, or the like.

### Background Art

GB-A-2393 321 discloses a magnetron sputtering apparatus having two inner magnet devices being located within a magnet arrangement and each comprising a quadrupolar array of magnets. Each magnet comprises a continuous magnetic row of small magnets which are disposed to form a unitary length of magnet.

US-B1-6351 075 discloses a plasma processing apparatus which includes a pair of a first rotary permanent magnet system and a second rotary permanent magnet system each of which includes individual permanent magnets. The first and second rotary permanent magnet systems are extended straight along an axis.

On manufacturing liquid crystal display elements, semiconductor devices such as ICs and so forth, a thin film formation process is indispensable so as to form, on a substrate, a thin film, such as metal or insulator or the like. With this process, a film formation method has been employed which uses a sputtering apparatus wherein a raw material for thin film formation is used as a target. In this event, plasma is caused to occur in an argon gas or the like by giving DC high-voltage or high-frequency power to activate and dissolve the target and to scatter the material of the target to deposit the same onto a substrate to be processed.

Among sputtering film formation methods, a main recent trend is directed to a film formation method which uses a magnetron sputtering apparatus. In such a magnetron sputtering apparatus, high film formation speed can be accomplished by disposing a magnet at the rear side of the target, and by running magnetic lines of force in parallel with the target surface, thereby confining plasma on the target surface, and generating high-density plasma.

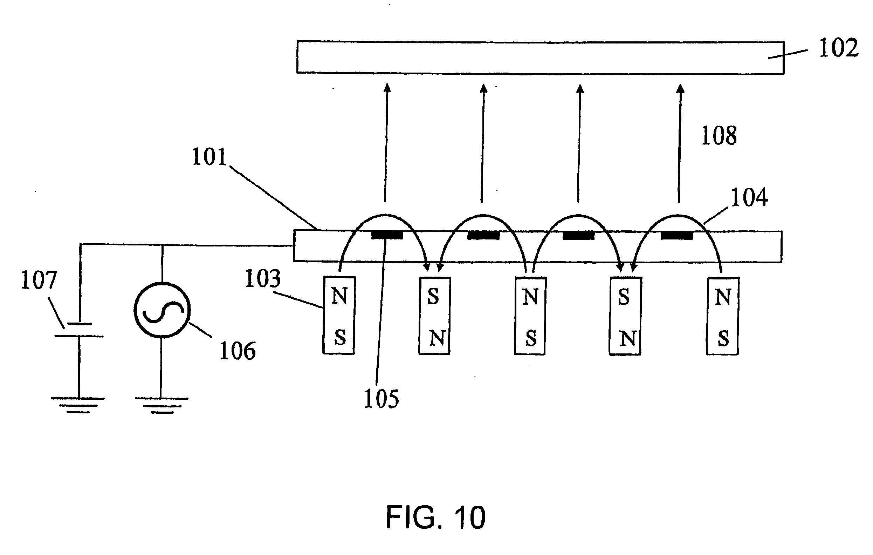

Fig. 10 is a diagram for describing principal component configurations of a magnetron sputtering apparatus according to such an existing technique, wherein reference numeral 101 denotes a target, 102 denotes a substrate for forming a thin film, 103 denotes multiple magnets, 104 denotes magnetic lines of force, and 105 denotes a region where the target 101 is dissolved and exfoliated, i.e., an erosion region.

As shown in Fig. 10, the multiple magnets 103 are disposed at the rear side of the target 101 with the N pole and S pole of each of the multiple magnets 103 directed toward a predetermined direction, and high-frequency power (RF power) 106 or DC high-voltage power 107 is applied between the target 101 and substrate 102 to excite plasma on the target 101.

On the other hand, the multiple magnets 103 installed at the back face of the target 101 generate magnetic lines of force104 from the N pole to S pole which are adjacent to each other. With the target surface, the horizontal magnetic field (magnetic line components in parallel with the target surface) partially becomes the maximum at a position where the vertical magnetic field (magnetic field line components perpendicular to the target surface) is zero. With a region including many horizontal magnetic field components, electrons are captured near the target surface to form high-density plasma, and accordingly, an erosion region 105 is formed with this position as the center thereof.

The erosion region 105 is exposed to high-density plasma as compared with other regions, so the target 101 is intensely locally worn. When the target material is depleted at a locally worn region by continuing film formation, the whole target needs to be replaced. As a result, utilization efficiency of the target 101 deteriorates, and further, the film thickness of the thin film of the substrate 102 which is opposed to the target 101 also becomes uneven so that the film thickness of the position facing the erosion region 105 becomes thick, and the thickness uniformity of the whole substrate 102 deteriorates.

Therefore, techniques have been proposed conventionally wherein bar magnets are used as the magnets for generating magnetic fields, and the bar magnets are moved or rotated, thereby moving the erosion region over time, substantially eliminating partial wear of a target at time average, and further, improving uniformity of the film thickness of a substrate to be processed (see Patent Documents 1 through 3).

With these techniques, the N pole and S pole of the bar magnets are arranged so that the same magnetic poles are placed on an opposite surface in the diameter direction and embedded in parallel with the longitudinal direction of the magnets. Alternatively, the same poles are arranged in a spiral manner in the opposite surface in the diameter direction and are placed along a longitudinal direction. Further, a fixed bar magnet is disposed around the bar magnets which are movable or rotated, to form a closed loop of an erosion region within the target. With this fixed bar magnet, the N pole and S pole have each array of the same magnetic pole on the surface facing in the diameter direction thereof in parallel with the longitudinal direction thereof.

Patent Document 1: Japanese Unexamined Patent Application Publication No. 5-148642
Patent Document 2: Japanese Unexamined Patent Application Publication No. 2000-309867
Patent Document 3: Japanese Patent No. 3566327

### Disclosure of Invention

### Problems to be Solved by the Invention

However, it is to be noted with the above-mentioned existing techniques that, in order to increase film formation speed as to the substrate to be processed, instantaneous erosion density should be increased. That is, in order to set an erosion region to a great percentage as to the entire target region, the strength of the bar magnets needs to be enhanced, and bar magnets are further reduced in size and should be closed to each other. However, employing such an arrangement has caused a problem wherein the magnets or fixed bars are deformed due to repelling power or suction power between magnets, or movement or rotation cannot be readily performed against such power.

Also, employing such an arrangement has also caused a problem to occur in the following. Namely, when the magnets adjacent to the bar magnet fixed on the periphery are rotated, a phase inevitably occurs such that the magnetic pole of the rotating magnets is identical to the magnetic pole of the bar magnet fixed on the periphery, and at this time, a closed erosion is not formed.

To this end, the present invention has been made in light of the above-mentioned existing problems, and one object thereof is to provide a magnetron sputtering apparatus which enables film formation speed to be improved by increasing instantaneous erosion density on a target.

Further, another object of the present invention is to provide a magnetron sputtering apparatus which enables the life of a target to be prolonged by moving an erosion region over time to prevent partial wear of the target, and realize uniform wear.

### Means to Solve the Problems

In order to achieve the above-mentioned object, according to the present invention, there is provided a magnetron sputtering apparatus which comprises: a substrate to be processed; a target facing the substrate; and a magnet placed at an opposite side of the target relative to the substrate in which plasma is confined on the target surface by generating a magnetic field by the magnet on the target surface; wherein the magnet includes a rotating magnet group wherein a plurality of plate-like magnets are arranged around a columnar rotating shaft, and a fixed outer circumferential frame magnet which is arranged in parallel with the target surface around the rotating magnet group, and which is magnetized in the direction perpendicular to the target surface; and wherein a magnetic-field pattern at the target surface is moved with time by rotating the rotating magnet group together with said columnar rotating shaft.

Herein, the rotating magnet group is configured by installing a plurality of plate-like magnets at the outer circumference of the columnar rotating shaft such that plate-like magnets adjacent to each other in the axial direction of the columnar rotating shaft have magnetic poles different from each other, and plate-like magnets adjacent to each other have different magnetic pole portions at an outer circumferential surface perpendicular to the axial direction of the columnar rotating shaft. The fixed outer circumferential frame magnet has either the N pole or S pole faced toward the target side.

The rotating magnet group has the plate-like magnets arranged in a spiral shape around the columnar rotating shaft so as to form a plurality of spirals, and the spirals adjacent to each other in the axial direction of the columnar rotating shaft form the N pole and S pole which are mutually different magnetic poles at the outer side in the diameter direction of the columnar rotating shaft. The fixed outer circumferential frame magnet has a configuration surrounding the rotating magnet group as viewed from the target side, and has either the N pole or S pole faced toward the target side.

The rotating magnet group may be configured by installing plate-like magnets at the outer circumference of the columnar rotating shaft in a ring shape, and providing a plurality of the rings in the axial direction of the columnar rotating shaft, and is configured such that the rings adjacent to each other in the axial direction of the columnar rotating shaft mutually have different magnetic poles, and the position in the axial direction of the columnar rotating shaft of the plate-like magnets of each ring is changed as the angle in the diameter direction of the columnar rotating shaft is changed. The fixed outer circumferential frame magnet has a configuration surrounding the rotating magnet group as viewed from the target side, and has either the N pole or S pole faced toward the target side.

Preferably, at least a part of the columnar rotating shaft is a paramagnetic material.

A fixed outer circumferential paramagnetic material member may be placed adjacent to the fixed outer circumferential frame magnet on the opposite side of the fixed outer circumferential frame magnet relative to the target.

The apparatus may comprise means for weakening the magnetic flux extended toward the outside of the target from the fixed outer circumferential frame magnet, as compared with the magnetic flux extended toward the inner side of the target from the fixed outer circumferential frame magnet.

Preferably, the above-mentioned means includes a paramagnetic material member provided so as to consecutively cover the outside surface of the fixed outer circumferential frame magnet, as viewed from the target side and a part of the face of the target side.

The means may be configured so that the fixed outer circumferential frame magnet has the surface protruded toward the inner side of the target.

The magnetron sputtering apparatus may further comprise a shielding member which is remote from the target so as to cover the edge portion of the target and which is placed on the opposite side of the spiral plate-like magnet group, and grounded electrically. The shielding member has a slit which extends in the same direction as the axial direction of the columnar rotating shaft and which exposes the target relative to the substrate to be processed. The width and length of the slit are set so that a region not smaller than 75% of a maximum value is opened when it is viewed from the substrate to be processed. The maximum value is determined by the time average distribution of the magnetic field strength of a component parallel with the target surface of the magnetic field formed on the target surface when the plate-like magnet group is rotated at a constant frequency.

The magnetron sputtering apparatus may further comprise a shielding member which is remote from the target so as to cover the edge portion of the target and which is placed on the opposite side of the spiral plate-like magnet group, and grounded electrically. The shielding member has a slit which extends in the same direction as the axial direction of the columnar rotating shaft and which exposes the target relative to the substrate to be processed. The width and length of the slit are set so that a region not greater than 80% of a maximum film thickness is shielded. The maximum film thickness being film-formed on the substrate to be processed within a unit time when the substrate is fixed and the plate-like magnet group is rotated at a constant frequency with the edge portion of the target uncovered.

The fixed outer circumferential paramagnetic material member has a portion which consecutively forms a wall surface and which covers the columnar rotating shaft and the plate-like magnet group except for the target side and an extended portion extended to an adjacent portion to the columnar rotating shaft so as to adjoin the magnetic material portion of the columnar rotating shaft through a magnetic fluid. A magnetic circuit of which the magnetic resistance is low is formed between the rotating magnet group and the fixed outer circumferential frame magnet.

The rotating magnet group is formed by a plurality of ring-shaped plated-like magnet groups wherein a plurality of plate-like magnets are attached to the columnar rotating shaft in a ring shape. The ring-shaped plated-like magnet groups which are adjacent to each other in the axial direction of the columnar rotating shaft are formed by the ring-shaped plated-like magnet groups which provide the N pole and S pole mutually different magnetic poles at the outer side in the diameter direction of the columnar rotating shaft. The positions in the axial direction of each ring-shaped plated-like magnet group are consecutively changed with the same displacement as angles in the diameter direction of the columnar rotating shaft are being changed.

The ring-shaped plated-like magnet groups are formed so as to be moved to the axial direction position of the adjacent ring-shaped plate-like magnets when the angle in the diameter direction of the columnar rotating shaft is rotated by 180 degrees, and return to the original axial direction position when the angle in the diameter direction of the columnar rotating shaft is further rotated by 180 degrees. The fixed outer circumferential frame magnet has a configuration which surrounds the rotating magnet group as viewed from the target side and which has the magnetic pole of the N pole or S pole at the target side.

Preferably, at least a part of the columnar rotating shaft is formed by a paramagnetic material.

Preferably, a fixed outer circumferential paramagnetic material member is arranged adjacent to the fixed outer circumferential frame magnet on the opposite side of the fixed outer circumferential frame magnet relative to the target.

The fixed outer circumferential paramagnetic material member has a portion which consecutively forms a wall surface and which has a configuration covering the columnar rotating shaft and the rotating plated-like magnet groups except the target side. The fixed outer circumferential paramagnetic material member is further extended to the portion adjacent to the columnar rotating shaft to adjoin the magnetic material portion of the columnar rotating shaft through a magnetic fluid and to form a magnetic circuit which has a low magnetic resistance between the rotating magnet group and the fixed outer circumferential frame magnet.

The ring-shaped plate-like magnet groups may be formed so as to be moved to the axial direction position of the adjacent ring-shaped plate-like magnets when the angle in the diameter direction of the columnar rotating shaft is rotated by 180 degrees, and returned to the original axial direction position when the angle in the diameter direction of the columnar rotating shaft is further rotated by 180 degrees. The fixed outer circumferential frame magnet has a first plate-like magnet which is placed in the vicinity of one side of the rotating magnet group as viewed from the target side, and which provides a magnetic pole of either the N pole or S pole at the target surface side, and a plate-like magnet which has a configuration surrounding the ring-shaped rotating magnet group and the first plate-like magnet as view from the target side, and which has the magnetic pole opposite to the first plate-like magnet on the target side.

The ring-shaped plate-like magnet group may be formed so as to be moved to the axial direction position of the adjacent ring-shaped plate-like magnet when the angle in the diameter direction of the columnar rotating shaft is rotated by 180 degrees, and returned to the original axial direction position when the angle in the diameter direction of the columnar rotating shaft is further rotated by 180 degrees. The fixed outer circumferential frame magnet has a configuration surrounding the rotating magnet group as viewed from the target side, and forming the magnetic pole of the N pole or S pole at the target side.

Desirably, at least a part of the columnar rotating shaft is formed by a paramagnetic material.

A fixed outer circumferential paramagnetic material member is placed adjacent to the fixed outer circumferential frame magnet on the opposite side of the fixed outer circumferential frame magnet relative to the target.

The fixed outer circumferential paramagnetic material member may have a portion consecutively forming a wall surface and a configuration covering the columnar rotating shaft and rotating plate-like magnet group except the target side, and further extends to the portion adjacent to the columnar rotating shaft to adjoin the magnetic material portion of the columnar rotating shaft through a magnetic fluid, and to form a magnetic circuit which has a low magnetic resistance between the rotating magnet group and the fixed outer circumferential frame magnet.

The columnar rotating shaft, the rotating magnet group adhered to the columnar rotating shaft, and the fixed outer circumferential frame magnet are movable in a direction perpendicular to the target surface.

The rotating magnet group and the fixed outer circumferential frame magnet may be arranged within space surrounded with a wall surface consecutively installed from a target member, a backing plate to which the target member is adhered, and around the backing plate, and the space can be reduced in pressure.

The magnetron sputtering apparatus may further comprise means for relatively moving the substrate to be processed in a direction intersecting the axial direction of the columnar rotating shaft.

An apparatus may comprise a plurality of magnetron sputtering apparatuses mentioned above in parallel with the axial direction of the columnar rotating shaft; and means for relatively moving the substrate to be processed in a direction intersecting the axial direction of the columnar rotating shaft.

A sputtering method for forming the material of the target to deposit a film of the material on a substrate to be processed while rotating the columnar rotating shaft may be carried out by using the magnetron sputtering apparatus mentioned above.

A method for manufacturing an electronic device including a process for employing the sputtering method mentioned above may be carried out to form a film on a substrate to be processed by sputtering.

### Advantages

According to the present invention, film formation speed can be improved, and the life of a target can be prolonged by preventing the partial wear of the target, and realizing uniform wear.

### Brief Description of the Drawings

Fig. 1 is a cross-sectional view of a magnetron sputtering apparatus according to the present invention.
Fig. 2 is a bird's-eye view and a view taken along an arrow from a target side regarding a columnar rotating shaft, multiple magnet groups, a frame magnet, and a paramagnetic material member.
Fig. 3 is a diagram illustrating erosion regions.
Fig. 4 is a diagram illustrating a reciprocation type film forming apparatus according to an eighth embodiment of the present invention.
Fig. 5 is a diagram illustrating relative permeability dependency of a columnar rotating shaft material of horizontal magnetic field strength.
Fig. 6 is a diagram illustrating a normalization horizontal magnetic field strength in cases of (1) without magnetic circuit formation, (2) installation of a paramagnetic material member under a fixed outer circumferential frame magnet (relative permeability 100), and (3) formation of a magnetic circuit between a paramagnetic material and a columnar rotating shaft under a fixed outer circumferential frame magnet.
Fig. 7 is a diagram illustrating a erosion pattern in a case wherein of rotating plate-like magnets, only a magnet of which the magnetic pole of the outer side in the diameter direction of the columnar rotating shaft is the S pole, i.e., is equal to the magnetic pole at the target side of the fixed outer circumferential frame magnet, is reduced in length in the axial direction.
Fig. 8 is a diagram illustrating a magnet layout according to a third embodiment of the present invention.
Fig. 9 is a diagram illustrating a magnet layout according to a fourth embodiment of the present invention.
Fig. 10 is a diagram illustrating an existing magnetron sputtering apparatus.
Fig. 11 is an apparatus cross-sectional view according to a fifth embodiment of the present invention.
Fig. 12 is a diagram illustrating magnet interval dependency of horizontal magnetic field strength.
Fig. 13 is a diagram illustrating fixed outer circumferential magnet width dependency of horizontal magnetic field strength.
Fig. 14 is a diagram illustrating vertical direction distance dependency from the face at the target side of a fixed outer circumferential magnet of horizontal magnetic field strength.
Fig. 15 is a diagram illustrating a magnet arrangement according to a sixth embodiment of the present invention.
Fig. 16 is a diagram of spiral plate-like magnet groups and a fixed outer circumferential frame magnet.
Fig. 17 is a diagram imitating a plasma photograph at a target surface.
Fig. 18 is a diagram imitating a photograph of a wear state of a target after prolonged electric discharge.
Fig. 19 is a diagram illustrating a magnet arrangement according to a seventh embodiment of the present invention.
Fig. 20 is a diagram illustrating a film formation rate distribution in the direction perpendicular to the axis of a columnar rotating shaft in the case of installing a silicon substrate at a position distant 30 mm facing a target surface.
Fig. 21 is a contour map of a horizontal magnetic field distribution at the target surface.
Fig. 22 is a diagram illustrating antenna ratio dependency of yield of an antenna MOS capacitor.
Fig. 23 is a diagram illustrating yield of an antenna MOS capacitor.
Fig. 24 is a diagram illustrating pressure dependency of electron temperature, electron density, and plasma potential of plasma measured with a Langmuir probe.
Fig. 25 is a diagram illustrating a magnet layout according to a ninth embodiment of the present invention.
Fig. 26 is a diagram illustrating a magnet arrangement according to another ninth embodiment of the present invention.

### Reference Numerals

- 1: target
- 2: columnar rotating shaft
- 3: spiral plate-like magnet group
- 4: fixed outer circumferential frame magnet
- 5: outer circumferential paramagnetic material member
- 6: backing plate
- 7: housing
- 8: passage
- 9: insulating material member
- 10: substrate to be processed
- 11: inner space of a processing chamber
- 12: feeder wire or line
- 13: cover
- 14: outer wall
- 15: paramagnetic material member
- 16: ground plate

### Best Mode for Carrying Out the Invention

Embodiments of the present invention will be described below with reference to the drawings.

### (First Embodiment)

A first embodiment of the present invention will be described in detail with reference to the drawings.

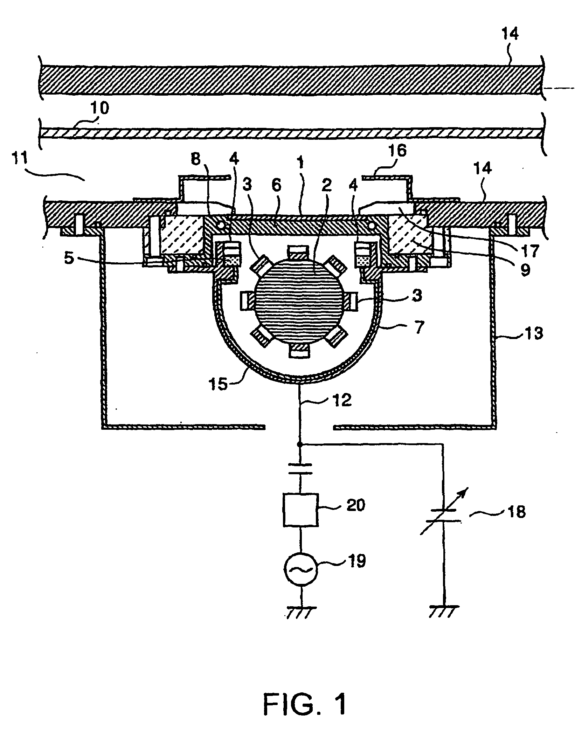

Fig. 1 is a cross-sectional view for describing the configuration of the first embodiment of a magnet rotating sputtering apparatus according to the present invention.

In Fig. 1, reference numeral 1 denotes a target; 2 denotes a columnar rotating shaft; 3 denotes multiple spiral plate-like magnet groups disposed in a spiral manner on the surface of the rotating shaft 2; 4 denotes a fixed circumferential magnet frame disposed around an outer circumference; 5 denotes an outer circumferential paramagnetic material member which is arranged on the fixed outer circumferential frame magnet 4 on an opposite side relative to the target; 6 denotes a backing plate attached to the target 1; 15 denotes a paramagnetic material member which covers the columnar rotating shaft 2 and the spiral plate-like magnet groups 3 on an opposite side of the target; 8 denotes a passage for allowing a coolant to pass therethrough; 9 denotes an insulating material member; 10 denotes a substrate to be processed; 11 denotes an inner space in a processing chamber; 12 denotes a feeder line;13 denotes a cover electrically connected to the processing chamber; 14 denotes an outer wall defining the processing chamber; 16 denotes a ground plate connected to the outer wall 14; and 17 denotes an insulating material member having an excellent property resistant to plasma.

The feeder line or wire 12 is electrically connected to DC power supply 18, RF power supply 19, and a matching box 20. From the DC power supply 18 and RF power supply 19, plasma excitation power is supplied to the backing plate 6 and target 1 via the matching box 20, further via the feeder wire 12 and housing, and plasma is excited along the target surface. Plasma can be excited with DC power alone or RF power alone, but applying both of them is desirable in view of film quality controllability and film formation speed controllability. Also, the frequency of RF power is usually selected from a frequency range between several hundred kHz and several hundred MHz, but a high frequency is desirable in view of high-density and low electron temperature of plasma. With the present embodiment, the frequency of RF power is set to 100 MHz. The ground plate 16 serves as a ground plate for RF power. By using this ground plate, plasma can be excited effectively even when the substrate to be processed is put into an electric floating state. The paramagnetic material member 15 has a magnetic shielding effect of a magnetic field generated at each magnet, and an effect for reducing fluctuation of a magnetic field due to disturbance in the vicinity of the target.

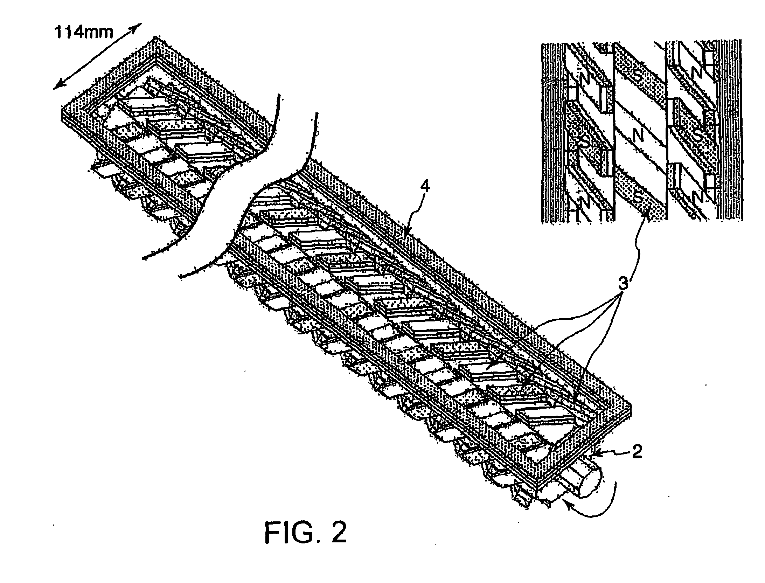

In order to describe a magnet portion in more detail, the columnar rotating shaft 2, multiple plate-like magnet groups 3, frame magnet 4, and paramagnetic material member 5 are illustrated in Fig. 2 by the bird's-eye view and by a plan view seen from the target 1 and backing plate 6 sides.

As for the material of the columnar rotating shaft 2, usual stainless steel or the like may be employed, but a part or the entirety thereof is preferably configured of a paramagnetic material of which the magnetic resistance is low, e.g., high-magnetic permeability alloy of Ni-Fe or the like. With the present embodiment, the columnar rotating shaft 2 is configured of an Ni-Fe high-magnetic permeability alloy. The columnar rotating shaft 2 can be rotated by a gear unit or motor (not shown).

The illustrated columnar rotating shaft 2 has a regular octagon in cross-section thereof and with the present embodiment, the length of one side of the regular octagon is set to 30 mm. A large number of rhombic-shaped plate-like magnets 3 are attached to each surface of the columnar rotating shaft 2. Thus, the illustrated columnar rotating shaft 2 has a configuration of attaching a magnet to the outer circumference thereof and can readily thicken the thickness. This structure is strong against bending due to magnetic force applied to the magnets. In order to generate a strong magnetic field in a stable manner, the plate-like magnets 3 are preferably made up of a magnet with high residual magnetic flux density, high coercive force, and high energy product, e.g., Sm-Co sintered magnets with residual magnetic flux density of around 1.1 T, and further Nd-Fe-B sintered magnets with residual magnetic flux density of around 1.3 T, and so forth. With the present embodiment, Nd-Fe-B sintered magnets are employed. The plate-like magnets 3 are magnetized in the vertical direction of the plate faces thereof, form multiple spirals by being adhered around the columnar rotating shaft 2 in a spiral manner, and the spirals adjacent to each other in the axial direction of the columnar rotating shaft mutually form different magnetic poles, i.e., the N pole and S pole directed toward the outer side in the diameter direction of the columnar rotating shaft.

The fixed outer circumferential frame magnet 4 has a structure surrounding the above-mentioned rotating magnet group as viewed from the target 2, and is magnetized so that the target 2 side of the frame magnet 4 has the S pole. With the present embodiment, the width thereof is set to 12 mm, and the thickness thereof is set to 10 mm. With regard to the fixed outer circumferential frame magnet 4 as well, an Nd-Fe-B sintered magnet is employed for the same reason as the plate-like magnets 3.

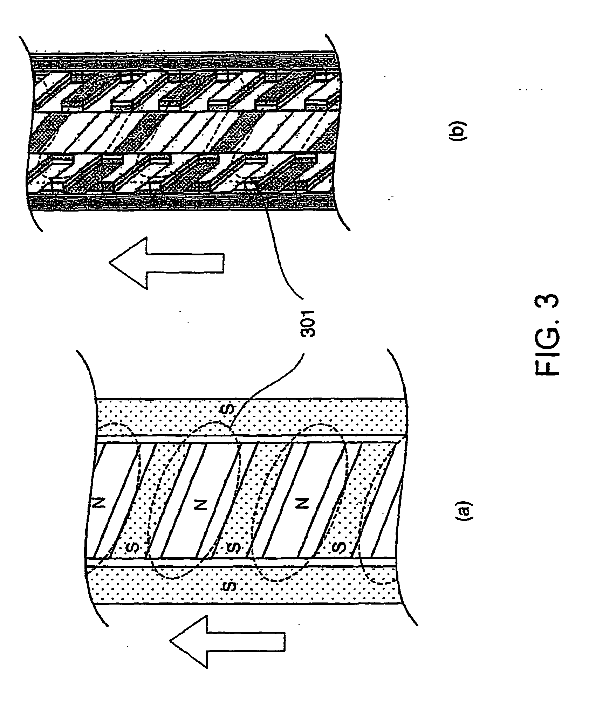

Next, description will be made about erosion formation according to the present embodiment in detail with reference to Fig. 3.

As described above, in the case where a great number of the plate-like magnets 03 are disposed on the columnar rotating shaft 2 in a spiral manner, upon viewing the plate-like magnets 3 from the target side, an arrangement is formed so that the S poles of the plate-like magnets 3 approximately surround the periphery of the N poles of the plate-like magnets 3. Fig. 3 (a) shows a conceptual view of the arrangement. Under such an arrangement, magnetic force lines generated from the N pole of the plate-like magnets 3 are terminated to the S pole of the periphery thereof. As a result, a great number of closed erosion regions 301 are formed on the target face somewhat distant from the surface of the plate-like magnets. Further, rotation of the columnar rotating shaft 2 brings about movement of a great number of the erosion regions 301 along with the rotation thereof. In Fig. 3 (b), the erosion regions 301 move in the direction indicated with the arrow. Note that with the edge portions of the rotating magnet group 3, erosion regions 301 are generated sequentially from one of the edge portions, and eliminated sequentially at the other edge portion.

Fig. 3 (b) illustrates the erosion regions 301 of the target surface distant by 21 mm from the surface of the fixed outer circumferential frame magnet 4 according to an actual configuration of the present embodiment. It is noted that a great number of the erosion regions 301 are formed. At the same time, it has been found out that the horizontal magnetic field of the erosion region 301, i.e., the magnetic field strength in parallel with the target face is as well as 310 Gauss, and accordingly, strength enough to confine plasma is obtained.

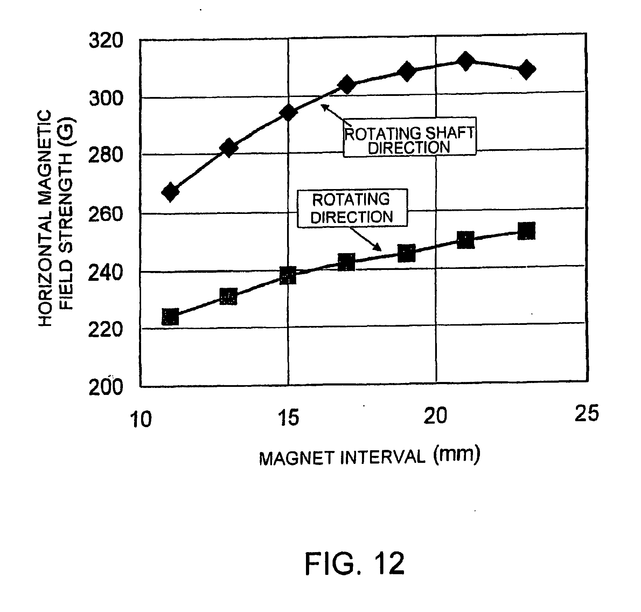

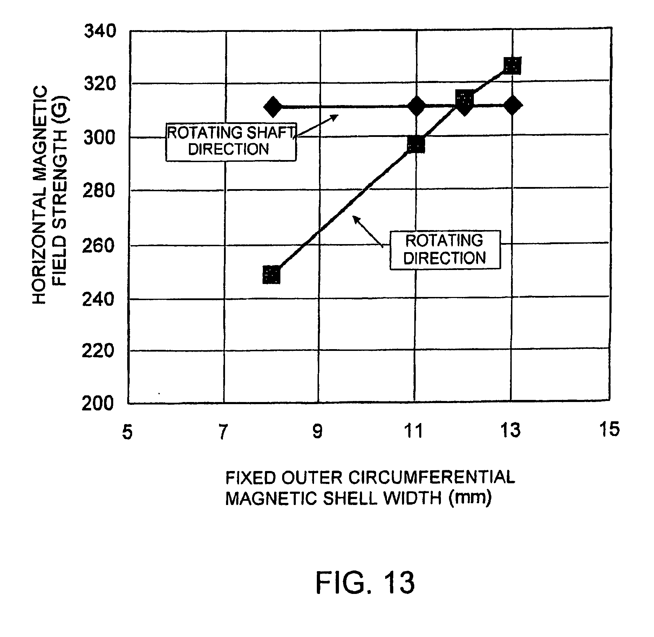

Now, description will be made as regards the horizontal magnetic field strength distribution of the erosion regions 301 with reference to Fig. 12 and Fig. 13. Fig. 12 represents the horizontal magnetic field strength of the erosion regions 301 on the target surface, with the length in the axial direction of the columnar rotating shaft 2 of the magnets of the plate-like magnet groups 3 fixed, and with the interval between adjacent spirals (magnet interval) changed. Illustration is made about the rotating shaft direction and the rotating direction perpendicular to the rotating shaft direction. When attention is focused on the rotating shaft direction, the maximum strength is around 310 Gauss at the magnet interval of around 20 mm. It has been found out that when the magnet interval is short, magnetic force lines generated between magnets do not leak and as a result, strong magnetic field strength is not obtained. To the contrary, when the magnet interval is too long, magnetic force lines are spread spatially, so the optimal value is obtained at a certain value.

It has been found out in Fig. 13 that the horizontal magnetic field strength alone in the rotating direction can be adjusted without almost influencing the horizontal magnetic field strength in the rotating shaft direction by changing the width of the fixed outer circumferential frame magnet 4. Thus, we have found that a uniform horizontal magnetic field can be obtained at any position of the erosion regions 301 by adjusting the size and/or interval of the plate-like magnet groups 3 and the fixed outer circumferential frame magnet 4.

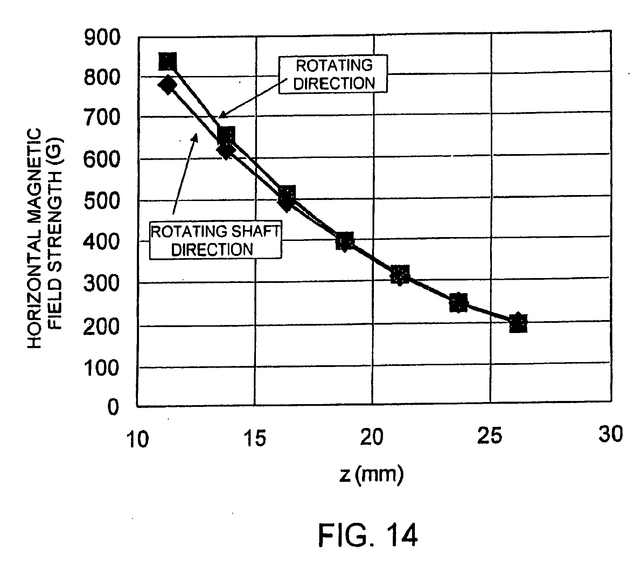

Next, Fig. 14 illustrates a relationship between the vertical distance to the target surface from the target side face of the fixed outer circumferential frame magnet 4 and the horizontal magnetic field strength. It has been found out from this graph that a further strong magnetic field can be obtained by closing the target surface to the fixed outer circumferential magnet 4.

It is to be noted that, although the present embodiment exemplified the regular octagon of the columnar rotating shaft 2 in cross-section and the plate-like magnets attached to each of the octagonal surfaces, the columnar rotating shaft 2 may have a regular polygon more than the regular octagon in cross-section and finer plate-like magnets to each of the polygonal surfaces in order to realize smoother spirals. Alternatively, the plate-like magnets may be changed in cross-section from a rectangle to a trapezoid of which the outside side is widened in the radial direction of the rotating shaft in order to close the adjacent plate-like magnets arranged in the spiral manner.

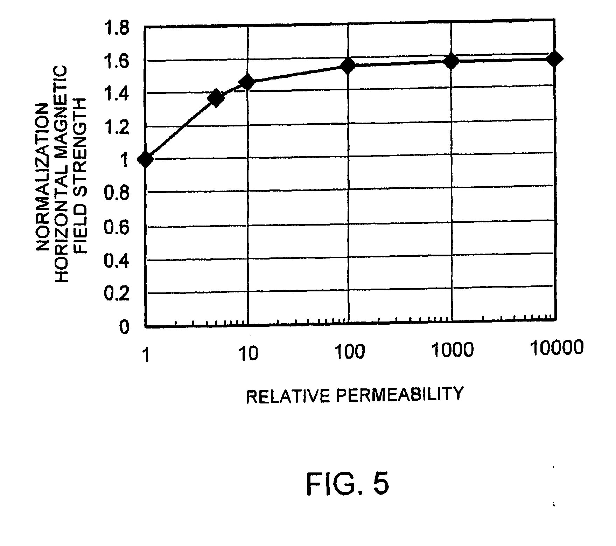

Next, description will be made with reference to Fig. 5 about an advantage obtained by changing the columnar rotating shaft 2 to a paramagnetic material.

Fig. 5 illustrates the relative permeability dependency of the horizontal magnetic field strength of the erosion regions 301, on the columnar rotating shaft 2. In Fig. 5, normalization is performed as the relative permeability is 1. According to Fig. 5, it has been found out that as the relative permeability of the columnar rotating shaft 2 increases, the horizontal magnetic field strength also increases, and particularly, when the relative permeability is equal to or greater than 100, magnetic field strength increases around 60%. This is because magnetic force lines have been able to be generated toward the target side effectively by reducing magnetic resistance at the rotating columnar shaft side of the plate-like magnets arranged in the spiral manner. Thus, a confining effect appearing on exciting plasma is improved, the electron temperature of the plasma is decreased, whereby damage to the substrate to be processed can be reduced. Thus, an increase of the plasma density brings about an improvement of film formation speed.

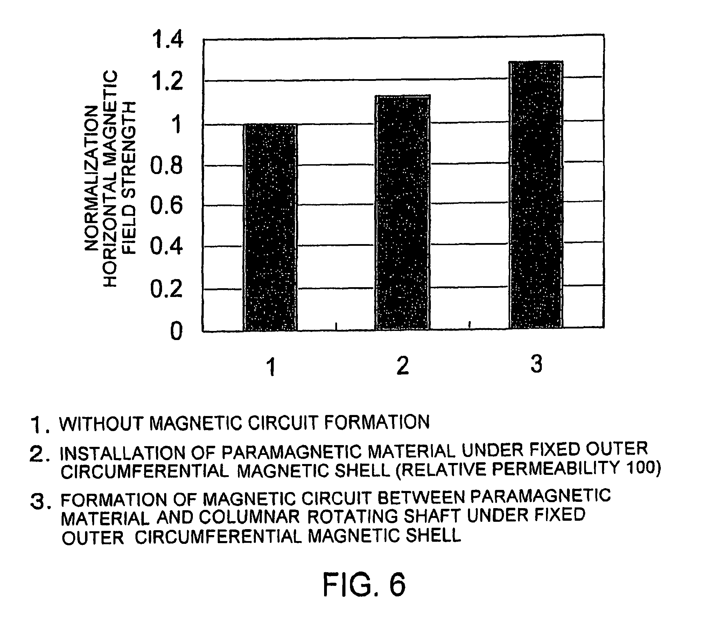

Further, as shown in Fig. 6, it has been found out that the normalized horizontal magnetic field strength is enhanced around 10% in the case of arranging a fixed outer circumferential paramagnetic material member as compared with the case of no arrangement of the above-mentioned paramagnetic material member. Further, the horizontal magnetic field strength is enhanced around 30% when a part of the fixed outer circumferential paramagnetic material member is extended to the portion adjacent to the columnar rotating shaft 2 and adjoins the magnetic material portion of the columnar rotating shaft 2 via a magnetic fluid, and a magnetic circuit of low magnetic resistance is formed between a rotating magnet group and the fixed outer circumferential frame magnet. In this case, the film formation performance is improved.

### (Second Embodiment)

A second embodiment of the present invention will be described in detail with the following drawing. Note that with regard to the portions redundant to the above-mentioned embodiment, description thereof will be omitted for convenience.

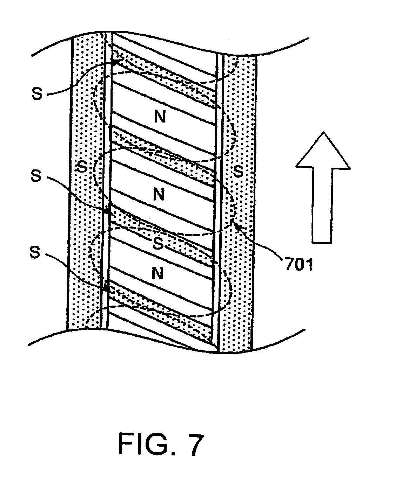

Fig. 7 illustrates an arrangement of rotating magnets according to the present embodiment. It is to be noted that the illustrated arrangement is different from that illustrated in the first embodiment in that, among the rotating magnets, the plate-like magnets which have S-poles directed to the outer side of the columnar rotating shaft 2, namely, the same magnetic poles as the magnetic poles of the fixed circumferential frame magnet directed toward the target side are shortened in length along the axis to provide a narrow width. This structure serves to increase the magnetic force lines which are generated from the N pole magnets and which are terminated at the fixed magnets of S poles as compared with the S poles of the plate-like magnets on the columnar rotating shaft. As a result, erosion regions 701 are linked together as shown in the drawing. Thus, the erosion regions 701 are linked simultaneously, whereby electrons move in and out as to each erosion region 701 freely according to drift. As a result, film formation with excellent uniformity can be realized without making the plasma density between the respective erosion regions 701 uneven. Note that linking between the erosion regions 701 can also be realized by reducing the residual magnetic flux density of the S pole magnet, or adjusting the distance between the rotating plate-like magnets.

### (Third Embodiment)

A third embodiment of the present invention will be described in detail with reference to the following drawing. Note that with regard to the portions redundant to the above-mentioned embodiments, description thereof will be omitted for convenience.

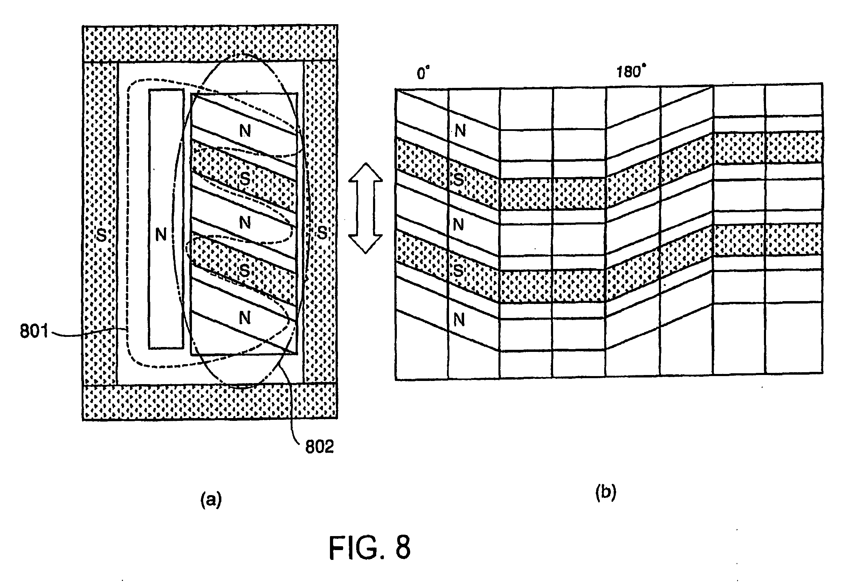

Fig. 8 (a) is a diagram illustrating an arrangement of the columnar rotating shaft 2, the plate-like magnets attached to the columnar rotating shaft 2, and the fixed outer circumferential frame magnet. The illustrated plate-like magnet groups 3 attached to the columnar rotating shaft 2 are formed by multiple ring-shaped and plate-like magnet groups adhered in ring shapes, and the ring-shaped plate-like magnet groups adjacent to each other in the axial direction of the columnar rotating shaft 2 mutually have different magnetic poles, i.e., the N poles and S poles at the outer side in the diameter direction of the columnar rotating shaft 2. Under such a configuration, as the angle in the diameter direction of the columnar rotating shaft 2 changes, the position in the axial direction of each ring-shaped and plate-like magnet group is consecutively changed. The rate of this change is preferably smoother.

Fig. 8(b) is a diagram expanding the surface of the columnar rotating shaft 2 along with the plate-like magnets adhered therein. As can be understood from the drawing, the ring-shaped plate-like groups are formed so as to be shifted relative to the axial direction position of the adjacent ring-shaped plate-like magnets when the angle in the diameter direction of the columnar rotating shaft changes 180 degrees, and returned to the original axial direction position when the angle changes further 180 degrees.

Also, as shown in Fig. 8(a),the fixed outer circumferential frame magnet has a first plate-like magnet which is installed in the vicinity of one side of the rotating magnet group and which has a magnetic pole, N pole directed toward the target surface as seen from the target face, together with a plate-like magnet portion which surrounds the ring-shaped rotating magnet group and the first plate-like magnet and which has a magnetic pole, namely S pole opposite to the first plate-like magnet and directed toward the target surface.

According to the present configuration, an erosion region 801 forms a single loop, and uniform plasma can be formed within the erosion region with an effect of drift electrons cyclically moving along the erosion region. Also, by rotating the columnar rotating shaft 2, a wave-shaped erosion area performs reciprocation in the axial direction along with the rotation thereof, which is formed of the ring-shaped plate-like group of the columnar rotating portion indicated with a dashed-two dotted line 802, and the fixed magnet of the periphery thereof. Thus, partial wear of the target can be prevented, and further, the erosion region 801 becomes a wave form, thereby increasing the ratio of the erosion area as to the target area, and realizing fast film formation speed.

### (Fourth Embodiment)

A fourth embodiment of the present invention will be described in detail with the following drawing. Note that with regard to the portions redundant to the above-mentioned embodiments, description thereof will be omitted for convenience.

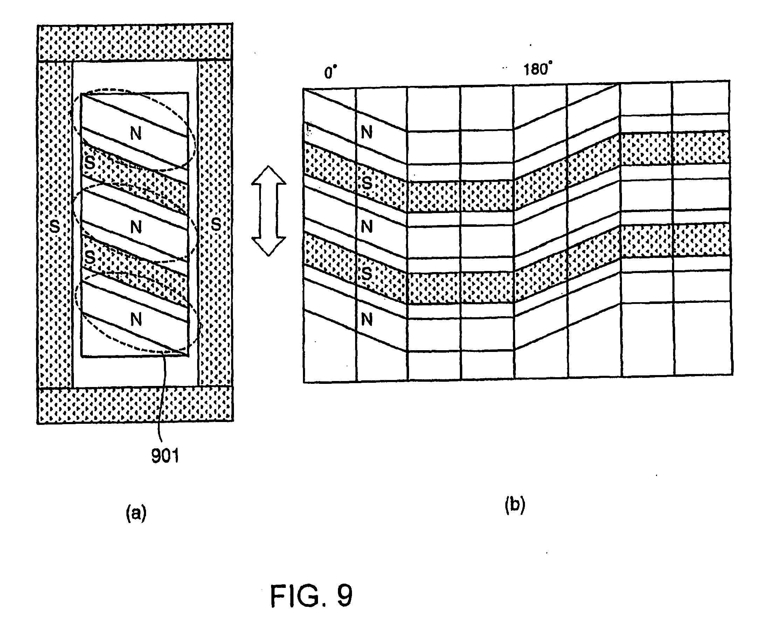

Fig. 9 (a) is a diagram illustrating an arrangement of the columnar rotating shaft 2, the plate-like magnets attached to the columnar rotating shaft 2, and the fixed outer circumferential frame magnet. With the plate-like magnet groups 3 attached to the columnar rotating shaft 2, multiple ring-shaped plate-like magnet groups are formed by attaching the plate-like magnets in a ring shape, and the ring-shaped plate-like magnet groups adjacent to each other in the axial direction of the columnar rotating shaft mutually provide different magnetic poles at the outer side in the diameter direction of the columnar rotating shaft 2, i.e., the N pole and S pole, and as the angle in the diameter direction of the columnar rotating shaft 2 changes, the position in the axial direction of each ring-shaped plate-like magnet group is consecutively changed.

Fig. 9 (b) is a diagram expanding the surface of the columnar rotating shaft along with the plate-like magnets adhered to the columnar rotating shaft. As can be understood from the drawing, the ring-shaped plate-like magnet group is formed so that the axial direction positions of the adjacent ring-shaped plate-like magnets are shifted when the angle in the diameter direction of the columnar rotating shaft 2 changes 180 degrees, and returned to the original axial direction position when the angle changes further 180 degrees. Thus, the fixed outer circumferential frame magnet makes up a configuration surrounding the rotating magnet group as viewed from the target surface, and also forms a magnetic pole which is specified by the S pole directed toward the target surface side in this figure.

According to the present configuration, each erosion region 901 reciprocally moves along the axial direction along with rotation of the rotating magnets, and the target is worn evenly. Also, unlike a spiral layout, no erosion region 901 is generated and eliminated at the rotating magnet edge portion, so fluctuation of plasma impedance is reduced, thereby enabling stable power supply. Also, it goes without saying that one magnetic pole of the ring-shaped plate-like magnet group is made similar to, for example, that in the second embodiment, whereby the axial direction width of the S pole magnet can be reduced as compared with the N pole magnet, or uniformity of plasma can be realized by adjusting the magnet interval to contact the erosion regions.

### (Fifth Embodiment)

A fifth embodiment of the present invention will be described in detail with the following drawing. Note that with regard to the portions redundant to the above-mentioned embodiments, description thereof will be omitted for convenience.

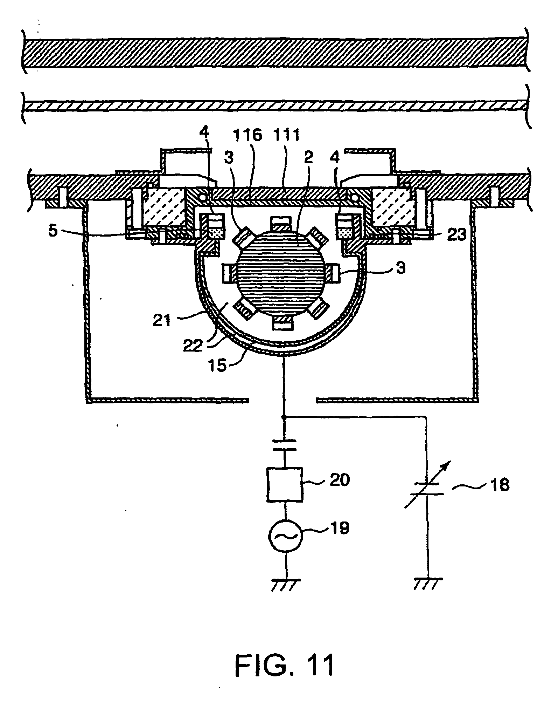

Fig. 11 is a cross-sectional view for describing the configuration of the fifth embodiment of the magnet rotating sputtering apparatus according to the present invention.

In Fig. 11, reference numeral 3 denotes multiple spiral plate-like magnet groups disposed on the surface of the columnar rotating shaft 2 in a spiral manner, 4 denotes fixed outer circumferential frame magnets disposed on the outer circumference, 5 denotes an outer circumferential paramagnetic material member disposed in the fixed outer circumferential frame magnets 4, facing the opposite side of the target, 15 denotes a paramagnetic material member making up a configuration covering the columnar rotating shaft 2 and spiral plate-like magnet groups 3 except for the target side, 18 denotes DC power supply, 19 denotes RF power supply, 20 denotes a matching box, 21 denotes a wall face installed consecutively from the periphery of a backing plate, 22 denotes space surrounded with the wall face 20 and backing plate, and 23 denotes a seal ring.

The seal ring 23 is installed, whereby pressure can be reduced at the space 22 using a vacuum pump (not shown). A gear unit and motor for rotating the columnar rotating shaft 2 may be installed within the reduced pressure space, or may be driven from the atmosphere side with a shaft seal provided. According to the present configuration, the pressure difference between the inside of the processing chamber and the space 22 decreases, whereby the thickness of the backing plate 116 can be reduced. In other words, according to the present configuration, the thickness of the target 111 can be increased, and the replacement frequency of the target is reduced, thereby improving productivity.

As the target material is being worn, the target surface is near to the magnets. As can be understood from Fig. 14, as the target surface is near to the magnets, magnetic field strength, plasma density, and film formation rate are increased. With the present embodiment, the columnar rotating shaft 2, fixed outer circumferential frame magnet 4, spiral plate-like magnet groups 3, fixed outer circumferential paramagnetic material 5, and paramagnetic material member 15 can be moved simultaneously with a linear guide (not shown) in the direction perpendicular to the target surface (thick line portions in the drawing). Accordingly, the distance to the target is separated from the backing plate by a wear amount of the target, whereby the same magnetic field strength is formed on the evenly worn target surface constantly. Thus, even when the target is worn, the same film formation speed as that in the initial stage is realized, and accordingly, a stable film formation result can be obtained constantly.

### (Sixth Embodiment)

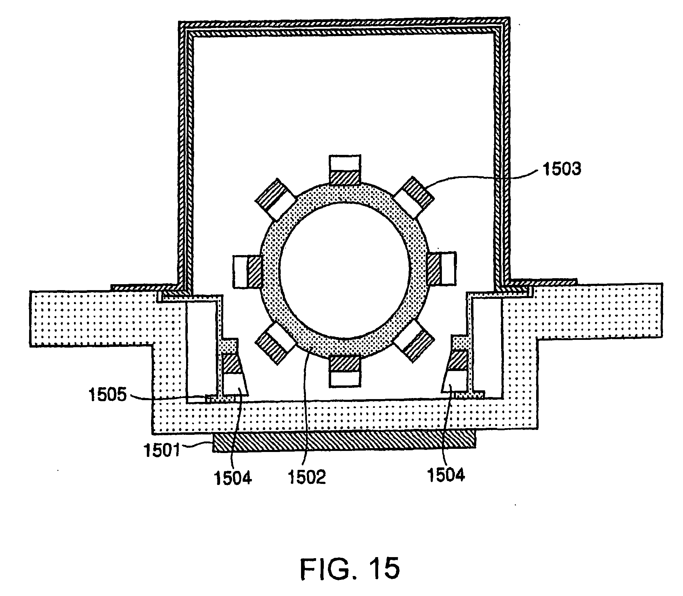

A sixth embodiment of the present invention will be described in detail with the following drawings. Note that with regard to the portions redundant to the above-mentioned embodiments, description thereof will be omitted for convenience. The present embodiment is for realizing improvement of the problems with the configuration shown in Fig. 1. That is to say, the present inventor and others have obtained the finding that in the case of employing the configuration shown in Fig. 1, the magnetic flux from the fixed outer circumferential frame magnet 4 flows out not only to the inner side portion of the target 1 but also to the outer side of the target generally with the same strength, which also generates plasma at the outside of the target, and this plasma causes a problem wherein this plasma spends excessive energy which does not contribute to sputtering, and also erodes the members other than the target. In order to prevent this problem, with the embodiment shown in Fig. 15, a device is added to the shape of the fixed outer circumferential magnet and the configuration of the fixed outer circumferential paramagnetic material member covering the fixed outer circumferential frame magnet.

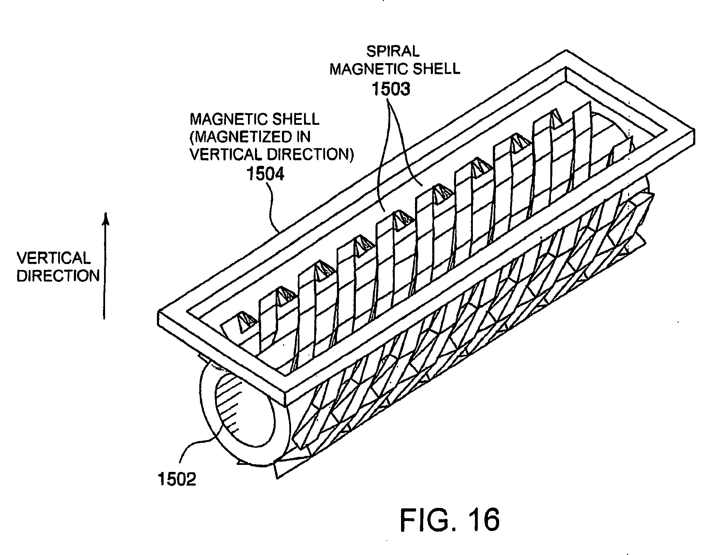

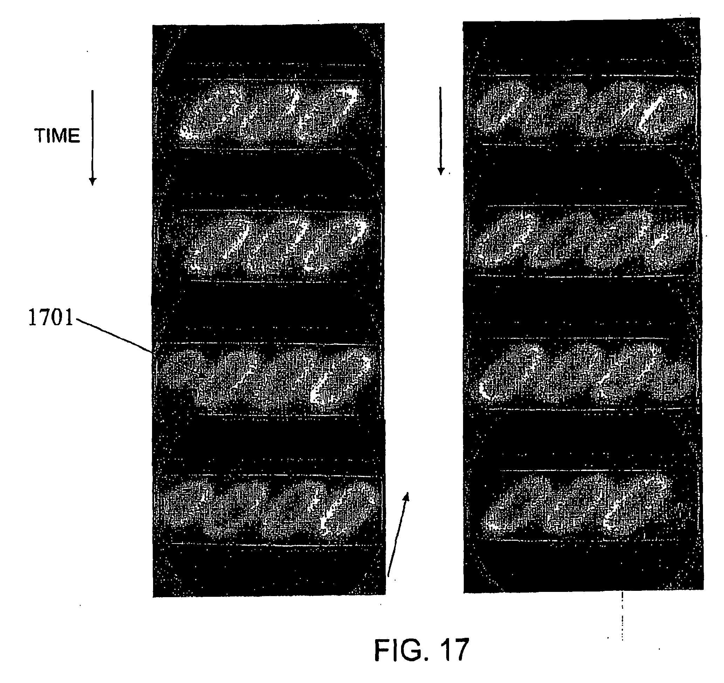

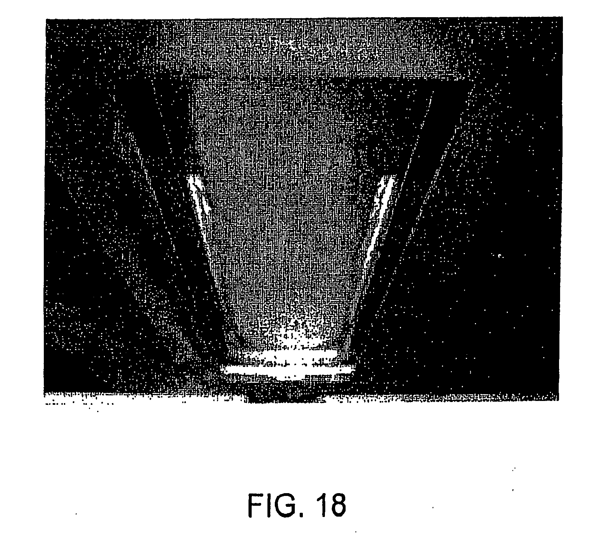

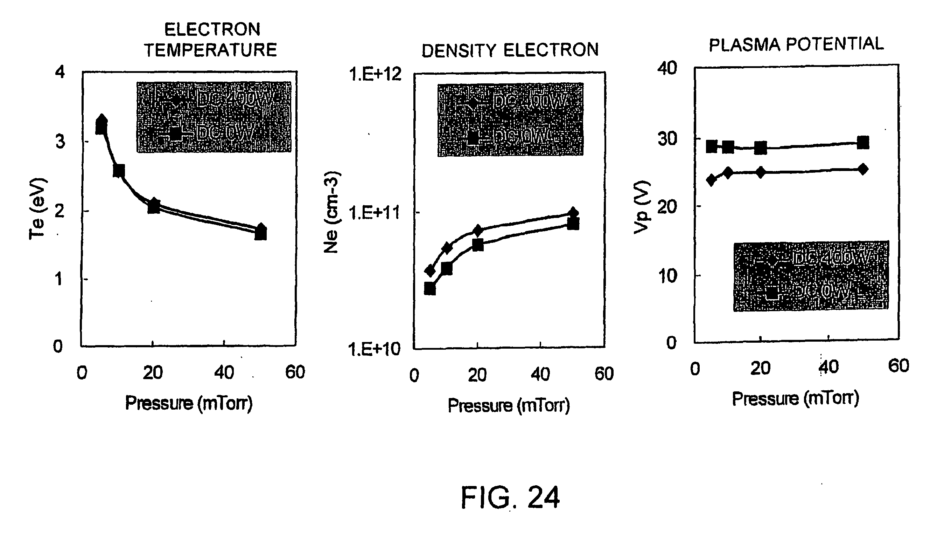

The sixth embodiment of the present invention will be described below with reference to Fig. 15. A columnar hollow rotating shaft 1502 is employed using a Ni-Fe high magnetic permeability alloy with the outer diameter of 74 mm, inner diameter of 58 mm, and thickness of 8 mm, with spiral plate-like magnets 1503 with the thickness of 12 mm being formed so as to be embedded 2 mm in the outer circumference thereof, as shown in Fig. 16. Note that in Fig. 16, the fixed outer circumferential frame magnet 1504 is also illustrated. The length in the axial direction of the spiral portion is 307 mm. The columnar rotating shaft 1502 is made up of a hollow configuration, thereby realizing reduction in weight. Also, as shown in Fig. 15, the fixed outer circumferential frame magnet 1504 is made up of a trapezoid configuration of 11 mm at the target 1501 side, 8 mm at the opposite side of the target, and 15 mm in height. Further, according to the sixth embodiment of the present invention, a fixed outer circumferential paramagnetic material member 1505 is continuously installed and arranged along the face of the opposite side of the target 1501, the side face of the outer side as viewed from the target side, of the fixed outer circumferential frame magnet 1504, and the region of the inner side of 7.3 mm from the outer side of the face of the target side, adjacent to the fixed outer circumferential frame magnet 1504. Thus, the magnetic flux from the fixed outer circumferential frame magnet 1504 is prevented from going to the outer side of the target, a horizontal magnetic field can effectively be formed only on the target face 1501 alone, and plasma can be excited with high efficiency only on the target face. A photograph of temporal change of plasma on the target surface at this time is shown in Fig. 17. As for plasma excitation conditions, argon gas is introduced 1000 cc per minute, and RF power of 13.56 MHz is supplied 800 W. The columnar rotating shaft is rotated at 1 Hz. As can be understood from a photograph at the left side of Fig. 17 (illustrating a situation changing from upward to downward over time), a plasma loop 1701 (erosion loop) is generated from the left edge of the rotating shaft in a stable manner, moved along with rotation, and as can be understood from a photograph at the right side in Fig. 17 (illustrating a situation changing from upward to downward over time), the target loop is eliminated from the right edge of the rotating shaft in a stable manner. Also, Fig. 18 illustrates a photograph in a worn state of the target after prolonged electric discharge. We can find from the drawing that the target surface is worn not partially but evenly. Also, Fig. 24 illustrates pressure dependency of electron temperature, electron density, and plasma potential of plasma measured with a Langmuir probe. The measured plasma is specified by argon gas plasma of which the RF power is 800 W, and measurement has been performed at a position distant 40 mm from the target surface. This illustrates no application of DC power and application of 400W. According to the drawing, we have found that particularly when pressure is equal to or greater than around 20 mTorr, electron temperature becomes equal to or smaller than 2 eV, and plasma with very low electron temperature is generated. The irradiation energy of ion irradiated on a substrate to be processed which is in an electric floating state is given with kTe / 2 × In (0.43 × mi / me), wherein k denotes a Boltzmann's constant, Te is electron temperature, mi denotes mass of plasma ion, and me is mass of electrons. In the case of argon gas, when electron temperature is equal to or smaller than 1.9 eV, ion irradiation energy becomes equal to or smaller than 10 eV, whereby damage to a base substrate at the time of early stages of film formation can be prevented as much as possible. Accordingly, with the early stages of film formation, film formation is preferably started at a high-pressure region.

### (Seventh Embodiment)

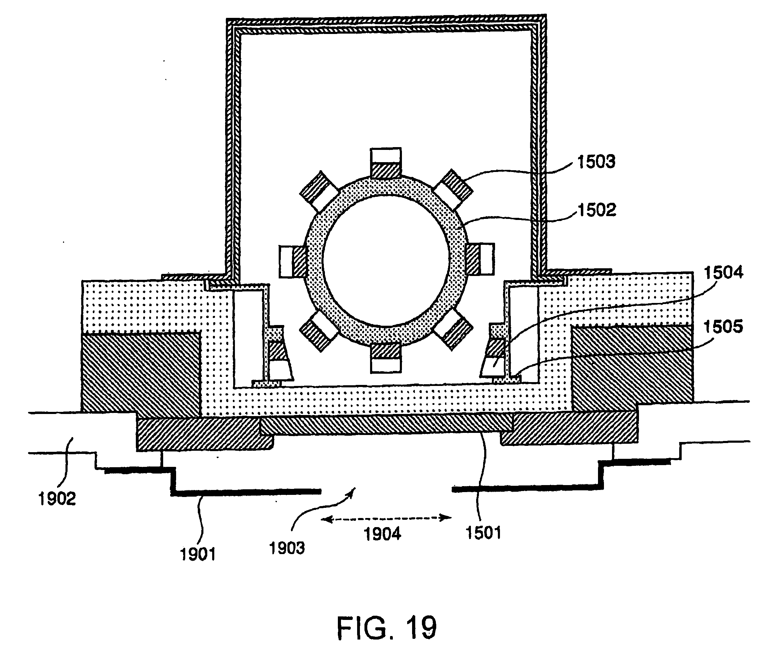

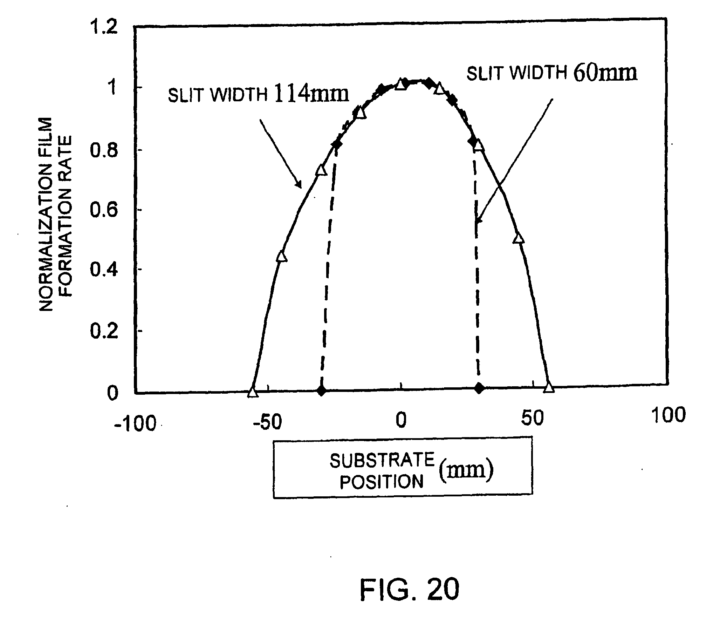

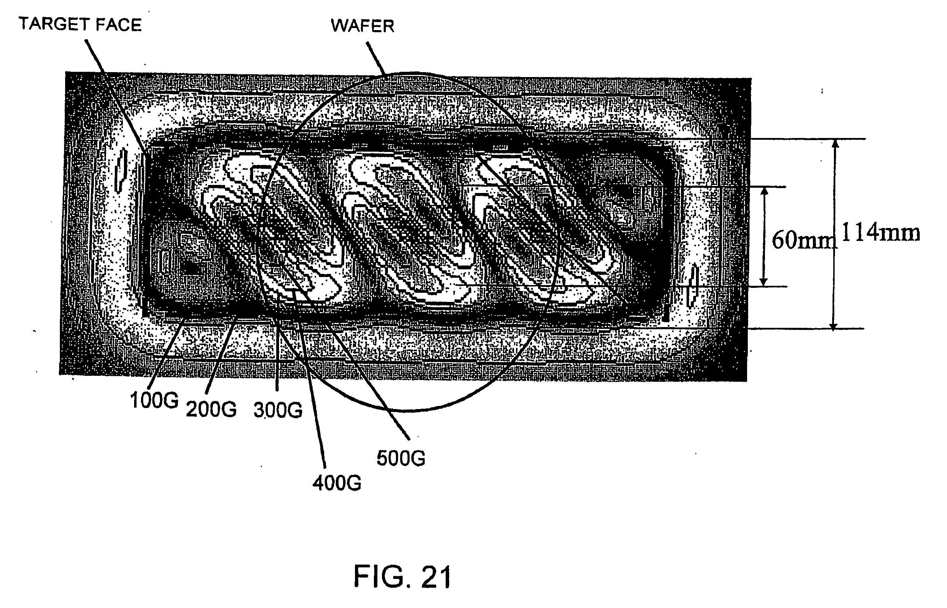

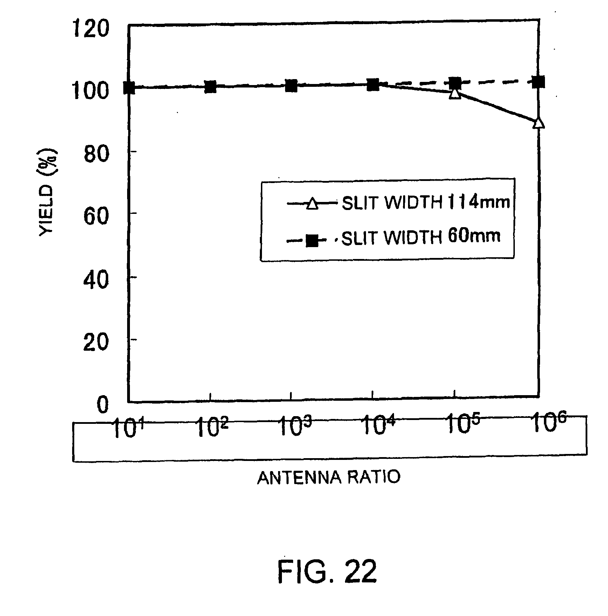

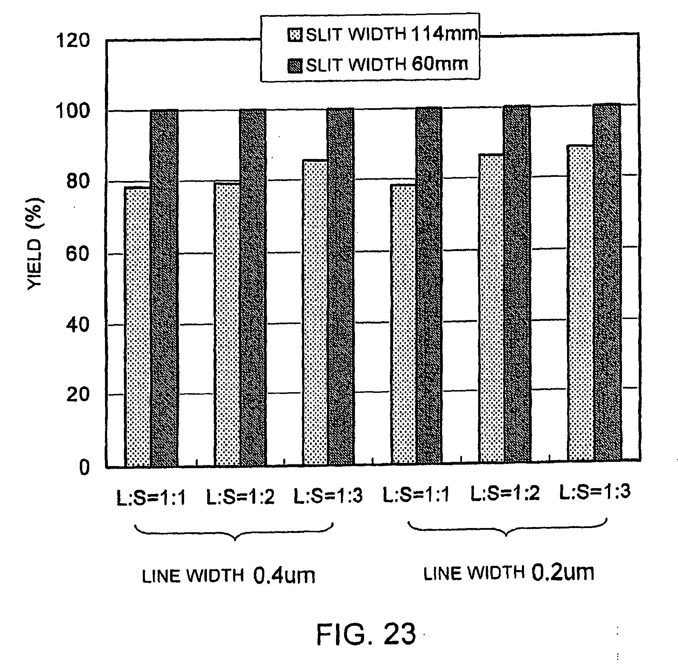

A seventh embodiment of the present invention will be described in detail with the following drawings. Note that with regard to the portions redundant to the above-mentioned embodiments, description thereof will be omitted for convenience. With the present embodiment, as shown in Fig. 19, a member 1901 electrically grounded extends and opens in the same direction as the axial direction of the spiral plate-like magnet group1503, thereby forming a slit 1903 for partially exposing the target 1501. The member 1901 is arranged on an opposite side of the target 1501 relative to the above-mentioned spiral plate-like magnets groups, namely, on a side of the substrate to be processed. The member 1901 partially covers an edge of the target 1501 and is isolated from the target 1501 to be connected to the processing chamber wall 1902. The member 1901 defines the slit 1903 partially exposing the target. That is to say, the ground plate 1901 has the slit. The width 1904 and length of the slit 1903 are set so as to shield a region where less than 80% of the maximum film thickness is deposited in the absence of the slit 1903 within a unit time on the substrate to be processed when the substrate to be processed is fixed and the spiral plate-like magnet group 1503 is rotated at a constant frequency. With the present embodiment, the material of the target is pure aluminum. Description will be made in more detail with reference to Fig. 20. Fig. 20 is a distribution of film formation rates in a direction perpendicular to the axis of the columnar rotating shaft when a silicon substrate is placed and opposed at a position remote from the target surface by 30 mm. Fig. 20 illustrates the cases of the slit width 1904 which is equal to 114 mm and 60 mm. In Fig. 20, normalization is performed by the use of the maximum film formation rate appearing at the center. The ground plate 1901 providing the slit 1903 is formed by a stainless plate with the thickness of 2 mm at a position remote from the target surface by 26 mm. The target width is as wide as 102 mm. In the case of the slit width of 114 mm, target particles substantially dispersed reach the silicon substrate without being shielded with the slit plate of 114mm, and a film is formed. On the other hand, in the case of the slit width of 60 mm, the portion equal to or smaller than 80% of the maximum film formation rate is shielded. Also, Fig. 21 illustrates a contour map or a level line map of a horizontal magnetic field distribution at the target surface. Fig.21 shows the case where the columnar rotating shaft takes a certain phase, but when substantially time average is taken regarding all of the phases, the maximum average horizontal magnetic field strength is 392 Gauss and in the case of the slit width of 60 mm, the region equal to or smaller than 295 Gauss. From this fact, it is understood that, when the slit width becomes equal to 60 mm, it is possible to shield a region which is not greater than 75 % of the maximum average horizontal magnetic field strength and which is not greater than 295G, when it is seen from the side of the substrate to be processed. In the case of the slit width of 60 mm, when film formation is performed upon the substrate to be processed, simultaneously with being irradiated with plasma, aluminum atoms are quickly deposited into a metal film, whereby electrification of the substrate to be processed can be prevented. Thus, charge-up damage can be prevented. Description will be made in more detail with reference to Fig. 22 and Fig. 23. Fig. 22 illustrates antenna ratio dependency of yield when aluminum is formed on a wafer of a 200-mm diameter on which antenna MOS capacitors (4 nm in oxide film thickness) are formed and their antenna ratios are changed from ten to one million. Each antenna ratio is represented by a ratio between a gate electrode (antenna electrode) area and a gate area of the MOS capacitors. The greater the antenna electrode is, the more plasma charges are collected. As the antenna electrode becomes large, an excessive magnetic field is applied to a gate insulating film, and consequently, an increase in leak current and dielectric breakdown are caused to occur. With the present embodiment, a silicon substrate is placed at a position remote by 30 mm from the target surface, and the substrate is moved at 1 cm per second reciprocally one-time under the slit in the direction perpendicular to the longitudinal direction of the slit so that all of the regions of the wafer pass through under the slit opening portion. Due to one-time reciprocating movement, all of the regions of the wafer pass through the slit opening portion twice. The film formation conditions are pressure of 80 mTorr, RF power of 1000 W, and DC power of 1000 W. As can be found from the drawing, it has been found out that when the slit width is equal to 114 mm, charge-up damage appears from the antenna ratio of a hundred thousand to make the yield deteriorate, but when the slit width is equal to 60 mm, damage does not appear until the antenna ratio of one million. Next, Fig. 23 illustrates search results wherein the antenna ratio is a ten thousand, an antenna MOS with a comb antenna is subjected to the same film formation, and the yield thereof has been searched. In Fig. 23, with the comb line widths of 0.2 µ m and 0.4µ m, the ratio of line-to-space is changed to 1:1, 1:2, and 1:3. As shown in the drawing, with the comb antenna as well, in the case of the slit width of 114 mm, with all of the conditions, charge-up damage appears to cause the yield to be around 80%, but in the case of the slit width of 60 mm, no damage is caused at all.

### (Eighth Embodiment)

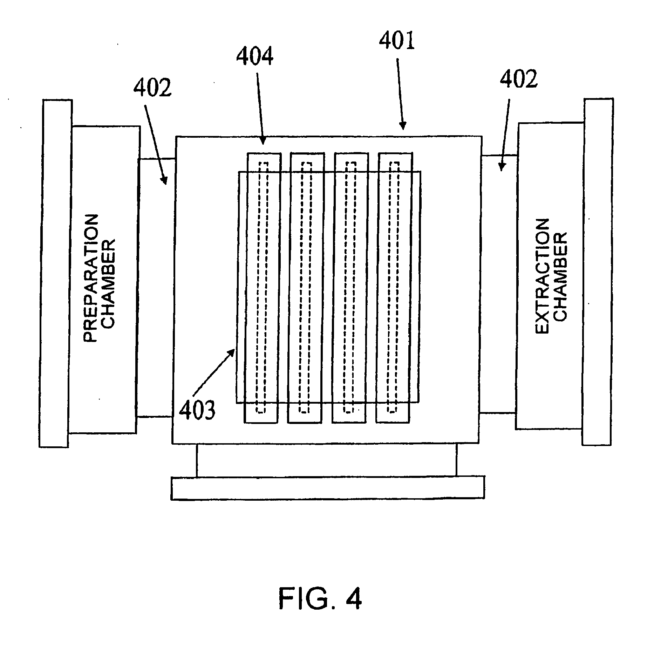

An eighth embodiment of the present invention will be described in detail with the following drawing. Note that with regard to the portions redundant to the above-mentioned embodiments, description thereof will be omitted for convenience. A rotating magnet sputtering apparatus according to the present invention is preferably employed as a reciprocation type film-forming apparatus as shown in Fig. 4.

In Fig. 4, reference numeral 401 denotes a processing chamber, 402 denotes a gate valve, 403 denotes a substrate to be processed, and 404 denotes a rotating magnet plasma exciting portion shown in the seventh embodiment. Note however, with the seventh embodiment, the length in the axial direction of the spiral portion is 307 mm, but with the present embodiment, the length is 2.7 m. With the present embodiment, the frequency of plasma excitation power is set to 13.56 MHz. This frequency is preferably a high frequency, e.g., around 100 MHz from the view of an increase in density and decrease in electron temperature of plasma, but with the present embodiment, the plasma excitation portion is around 2.7 m, and on the other hand, the wavelength of 100 MHz is 3 m. Thus, when the excitation portion is comparable to the wavelength, a standing wave is excited, and there is a possibility that plasma may become uneven. When the frequency is 13.56 MHz, the wavelength is 22.1 m, so the length of the plasma excitation portion is sufficiently shorter than the wavelength, and occurrence of uneven plasma can be avoided due to influence of the standing wave. With the present embodiment, four rotating magnet plasma excitation portions 404 are employed. Thus, the substantial film formation rate can be increased. The number of the excitation portions is not restricted to four. The substrate 403 to be processed is a glass substrate of 2.2 m x 2.5 m, and is installed by taking the vertical direction as 2.5 m with the present embodiment, whereby film formation can be performed substantially evenly on the substrate to be processed by subjecting the substrate to reciprocation in the vertical direction as to the columnar rotating shaft of the rotating magnet plasma excitation portion. In order to perform film formation evenly, the substrate 403 to be processed 403 may be passed through in one direction without performing reciprocation, or a method for moving the rotating magnet plasma excitation portion 404 may be employed. With the present embodiment, the substrate 403 to be processed is subjected to reciprocation, whereby a part of the substrate is consecutively exposed to the plasma region excited with the rotating magnet plasma excitation portion, and a thin film can be formed evenly. With regard to the rotation speed of the rotating magnet, time to make one rotation is set to be faster than the passage time of the substrate, whereby even film formation can be performed without being influenced by an instantaneous erosion pattern. Typically, the passage speed of the substrate is 60 seconds per sheet, and the rotation speed of the rotating magnet is 10 Hz. Note that with the present embodiment, the substrate to be processed has been subjected to reciprocation, but the apparatus can be configured as a passage film formation type apparatus for allowing a single or multiple rotating magnet plasma excitation portions to pass through only once to perform film formation.

### (Ninth Embodiment)

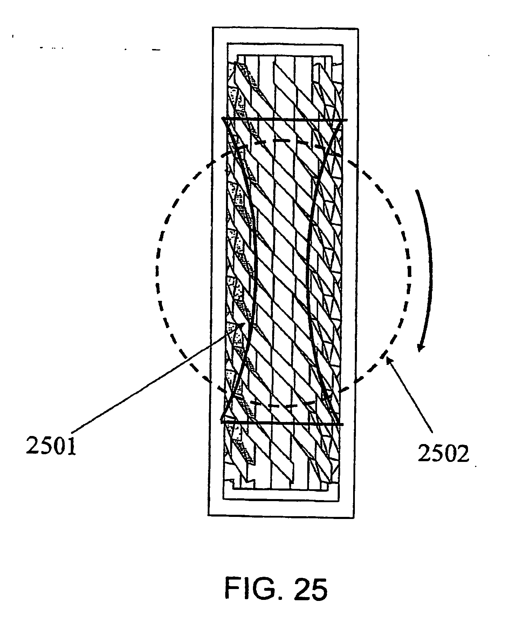

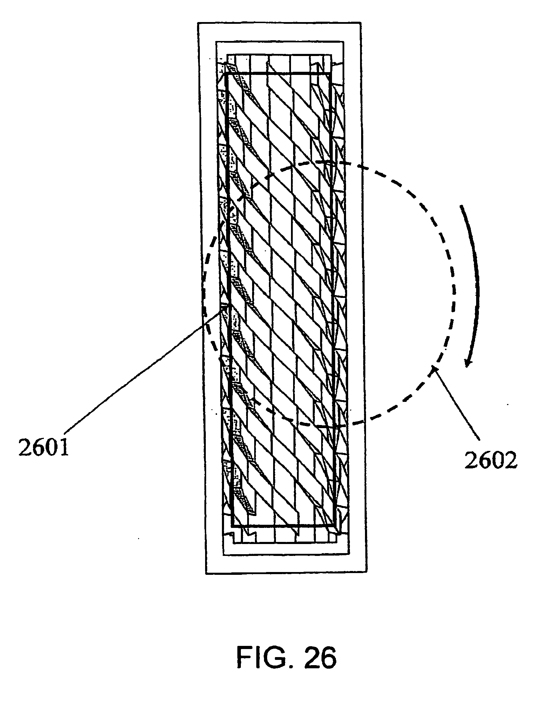

A ninth embodiment of the present invention will be described in detail with the following drawings. Note that with regard to the portions redundant to the above-mentioned embodiments, description thereof will be omitted for convenience. A rotating magnet sputtering apparatus according to the present invention is shown in Fig. 25. The columnar rotating shaft, rotating magnet groups, and fixed outer circumferential magnet have the same dimensions and configuration as those in the seventh embodiment. A substrate 2502 to be processed is a semiconductor wafer with the diameter of 200 mm, and is installed on a stage capable of rotation movement to be installed facing the target surface. Simultaneously with the columnar rotating shaft being rotated to generate plasma which is even at time average on the target surface, film formation has been performed on a wafer 2502 by rotating the above-mentioned stage. With a slit opening portion 2501, the slit width around the wafer center is narrowed down, whereby even film formation can be performed on the wafer. Also, as shown in Fig. 26, the slit opening portion 2601 is taken as a rectangle, and the center of a substrate 2602 to be processed is shifted from the center of the slit opening portion, whereby evenness of a film formation distribution can also be realized.

As described above, the present invention has been described with the embodiments, but the magnet dimensions, substrate dimensions, and so forth are not restricted to the embodiments.

### Industrial Applicability

A magnetron sputtering apparatus according to the present invention can be employed for forming an insulating film or a conductive film on a semiconductor wafer or the like, can also be applied to form a coat as to a substrate such as the glass of a flat display device or the like, and can be employed for sputtering film formation in manufacturing of a storage device and other electronic devices.

## Claims

1. A magnetron sputtering apparatus which comprises: a substrate to be processed (10); a target (1) facing the substrate (10); and a magnet (3, 4) placed at an opposite side of the target (1) relative to the substrate (10) in which plasma is confined on the target surface by generating a magnetic field by the magnet (3, 4) on the target surface;
wherein said magnet (3, 4) includes a rotating magnet group wherein a plurality of plate-like magnets (3) are arranged around a columnar rotating shaft (2), and a fixed outer circumferential frame magnet (4) which is arranged in parallel with the target surface around the rotating magnet group (3), and which is magnetized in the direction perpendicular to the target surface;
and wherein a magnetic-field pattern at said target surface is moved along a columnar direction of said columnar rotating shaft (2) by rotating said rotating magnet group (3),
wherein said rotating magnet group (3) is configured by installing a plurality of plate-like magnets (3) at the outer circumference of said columnar rotating shaft (2) such that plate-like magnets (3) adjacent to each other in the axial direction of said columnar rotating shaft (2) have magnetic poles different from each other, and plate-like magnets (3) adjacent to each other have different magnetic pole portions at an outer circumferential surface perpendicular to the axial direction of said columnar rotating shaft (2);
and wherein said fixed outer circumferential frame magnet (4) has either the N pole or S pole faced toward the target side, and
wherein said rotating magnet group (3) has the plate-like magnets arranged in a spiral shape around the columnar rotating shaft (2) so as to form a plurality of spirals, and the spirals adjacent to each other in the axial direction of said columnar rotating shaft (2) form the N pole and S pole which are mutually different magnetic poles at the outer side in the diameter direction of said columnar rotating shaft (2);
and wherein said fixed outer circumferential frame magnet (4) has a configuration surrounding said rotating magnet group (3) as viewed from the target side, and has either the N pole or S pole faced toward the target side.

2. The magnetron sputtering apparatus according to claim 1, wherein said rotating magnet group (3) is configured by installing plate-like magnets (3) at the outer circumference of said columnar rotating shaft (2) in a ring shape, and providing a plurality of the rings in the axial direction of said columnar rotating shaft (2), and is configured such that the rings adjacent to each other in the axial direction of said columnar rotating shaft (2) mutually have different magnetic poles, and the position in the axial direction of said columnar rotating shaft (2) of the plate-like magnets (3) of each ring is changed as the angle in the diameter direction of said columnar rotating shaft (2) is changed;
and wherein said fixed outer circumferential frame magnet (4) has a configuration surrounding said rotating magnet (3) group as viewed from the target side, and has either the N pole or S pole faced toward the target side.

3. The magnetron sputtering apparatus according to any one of claims 1 through 2, wherein:
the magnetic flux extended toward the outside of said target (1) from said fixed outer circumferential frame magnet (4) is weakened as compared with the magnetic flux extended toward the inner side of said target (1) from said fixed outer circumferential frame magnet (4).

4. The magnetron sputtering apparatus according to claim 3, wherein a paramagnetic material member (15) is provided so as to consecutively cover the outside surface of said fixed outer circumferential frame magnet (4), as viewed from said target side and a part of the face of said target side.

5. The magnetron sputtering apparatus according to claim 3 or 4,
wherein said fixed outer circumferential frame magnet (4) has the surface protruded toward the inner side of the target (1).

6. The magnetron sputtering apparatus according to any one of claims 1 through 5, further comprising:
a shielding member (1901) which is remote from said target (1) so as to cover the edge portion of said target (1) and which is placed on the opposite side of said spiral plate-like magnet group (3), and grounded electrically,
said shielding member (1901) having a slit (1903) which extends in the same direction as the axial direction of said columnar rotating shaft (2) and which exposes the target (1) relative to said substrate to be processed.

7. The magnetron sputtering apparatus according to claim 1, wherein said rotating magnet group (3) is formed by a plurality of plated-like magnet groups wherein a plurality of plated-like magnets (3) are attached to the columnar rotating shaft (2) in a ring shape,
said plated-like magnet groups which are adjacent to each other in the axial direction of the columnar rotating shaft (2) being formed by the plated-like magnet groups which provide the N pole and S pole mutually different magnetic poles at the outer side in the diameter direction of said columnar rotating shaft;
the positions in the axial direction of each plated-like magnet group being consecutively changed with the same displacement as angles in the diameter direction of said columnar rotating shaft (2) are being changed.

8. The magnetron sputtering apparatus according to claim 7,
wherein said plate-like magnet groups (3) are formed so as to be moved to the axial direction position of the adjacent plate-like magnets (3) when the angle in the diameter direction of said columnar rotating shaft (2) is rotated by 180 degrees, and returned to the original axial direction position when the angle in the diameter direction of said columnar rotating shaft (2) is further rotated by 180 degrees;
and wherein said fixed outer circumferential frame magnet (4) has a first plate-like magnet which is placed in the vicinity of one side of said rotating magnet group (3) as viewed from said target side, and which provides a magnetic pole of either the N pole or S pole at said target surface side, and a plate-like magnet which has a configuration surrounding said plate-like magnet groups (3) and said first plate-like magnet as view from the target side, and which has the magnetic pole opposite to said first plate-like magnet on said target side.

9. The magnetron sputtering apparatus according to claim 6 or 7,
wherein said plate-like magnet group (3) is formed so as to be moved to the axial direction position of the adjacent plate-like magnet (3) when the angle in the diameter direction of said columnar rotating shaft (2) is rotated by 180 degrees, and returned to the original axial direction position when the angle in the diameter direction of said columnar rotating shaft (2) is further rotated by 180 degrees, said fixed outer circumferential frame magnet (4) having a configuration surrounding said rotating magnet group as viewed from said target side, and forming the magnetic pole of the N pole or S pole at said target side.

10. The magnetron sputtering apparatus according to any one of claims 1 through 8, wherein at least a part of said columnar rotating shaft (2) is a paramagnetic material.

11. The magnetron sputtering apparatus according to any one of claims 1 through 9, wherein a fixed outer circumferential paramagnetic material member (15) is adjacent to said fixed outer circumferential frame magnet (4) on the opposite side of said fixed outer circumferential frame magnet (4) relative to the target (1).

12. The magnetron sputtering apparatus according to any one of claims 1 through 11, wherein said rotating magnet group (3) and said fixed outer circumferential frame magnet (4) are movable in a direction perpendicular to the target surface.

13. The magnetron sputtering apparatus according to any one of claims 1 through 12, wherein said rotating magnet group (3) and said fixed outer circumferential frame magnet (4) are arranged within space surrounded with a wall surface consecutively installed from a target member (1), a backing plate (6) to which the target member (1) is adhered, and around the backing plate (6), and said space can be reduced in pressure.

14. The magnetron sputtering apparatus according to any one of claims 1 to 13, wherein said substrate (10) to be processed is movable in a direction intersecting the axial direction of said columnar rotating shaft (2).

15. A magnetron sputtering system comprising: a plurality of magnetron sputtering apparatuses according to any one of claims 1 to 14 which are arranged in parallel with the axial direction of said columnar rotating shaft (2); wherein said substrate (10) to be processed is moved in a direction intersecting the axial direction of said columnar rotating shaft (2) over said plurality of the magnetron sputtering apparatuses.

## Patentansprüche

1. Magnetronsputtervorrichtung mit: einem zu bearbeitenden Substrat (10), einem Target (1), das auf das Substrat (10) zugerichtet ist, und einem Magneten (3, 4), der relativ zu dem Substrat (10) an einer gegenüberliegenden Seite des Targets (1) angeordnet ist, in dem ein Plasma auf der Targetoberfläche durch Erzeugung eines Magnetfeldes durch den Magneten (3, 4) auf der Targetoberfläche eingegrenzt ist,
wobei der Magnet (3, 4) eine rotierende Magnetgruppe umfasst, wobei eine Anzahl von plattenartigen Magneten (3) um eine säulenartige Drehwelle (2) angeordnet ist, und einen fixierten äußeren Umfangsrahmenmagneten (4), der parallel mit der Targetoberfläche um die rotierende Magnetgruppe (3) angeordnet ist und der in einer Richtung rechtwinklig zu der Targetoberfläche magnetisiert ist, und
wobei ein Magnetfeldmuster auf der Targetoberfläche entlang einer Säulenrichtung der säulenartigen Drehwelle (2) durch Drehen der rotierenden Magnetgruppe (3) bewegt wird,
wobei die rotierende Magnetgruppe (3) gebildet ist durch Installieren einer Anzahl von plattenartigen Magneten (3) an dem Außenumfang der säulenartigen Drehwelle (2) derart, dass plattenartige Magnete (3), die aneinander in der Axialrichtung der säulenartigen Drehwelle (2) angrenzend angeordnet sind, Magnetpole aufweisen, die sich voneinander unterscheiden, und wobei plattenartige Magneten (3), die aneinander angrenzen unterschiedliche Magnetpole an der äußeren Umfangsfläche rechtwinklig zur Axialrichtung der säulenartigen Drehwelle (2) aufweisen,
und wobei der fixierte äußere Umfangsrahmenmagnet (4) entweder N-Pole oder S-Pole zur Targetseite gerichtet hat,
und wobei die rotierende Magnetgruppe (3) plattenartige Magnete aufweist, die in Wendelform um die säulenartige Drehwelle (2) angeordnet ist, um eine Anzahl von Wendeln zu bilden und die Wendeln, die angrenzend aneinander in der Axialrichtung der säulenartigen Drehwelle (2) sind, N-Pole und S-Pole bilden, die gegenseitig unterschiedliche Magnetpole an der Außenseite in der Durchmesserrichtung der säulenartigen Drehwelle (2) sind,
und wobei der fixierte äußere Umfangsrahmenmagnet (4) einen Aufbau aufweist, der, gesehen von der Targetseite, die rotierende Magnetgruppe (3) umgibt und entweder die N-Pole oder die S-Pole in Richtung auf die Targetseite gerichtet aufweist.

2. Magnetronsputtervorrichtung nach Anspruch 1, wobei die rotierende Magnetgruppe (3) aufgebaut ist durch Installieren von plattenartigen Magneten (3) an dem äußeren Umfang der säulenartigen Drehwelle (2) in einer Ringform und durch Vorsehen einer Anzahl der Ringe in der Axialrichtung der säulenartigen Drehwelle (2) und so aufgebaut ist, dass die Ringe, die in Axialrichtung der säulenartigen Drehwelle (2) aneinander angrenzen, gegenseitig unterschiedliche Magnetpole aufweisen und die Position in Axialrichtung der säulenartigen Drehwelle (2) der plattenartigen Magnete (3) jedes Rings sich ändert wie sich der Winkel in der Durchmesserrichtung der säulenartigen Drewelle (2) ändert
und wobei der fixierte äußere Umfangsrahmenmagnet (4) einen Aufbau aufweist, der die Drehmagnetgruppe (3), gesehen von der Targetseite, umgibt und entweder N-Pole oder S-Pole aufweist, die in Richtung auf die Targetseite gerichtet sind.

3. Magnetronsputtervorrichtung nach einem der vorstehenden Ansprüche 1 bis 2, wobei:
der Magnetfluss, der sich nach Außen von dem Target (1) von dem fixierten äußeren Umfangsrahmenmagnet (4) erstreckt, verglichen mit dem Magnetfluss, der sich zur Innenseite des Targets (1) von dem fixierten äußeren Umfangsrahmenmagneten (4) erstreckt, geschwächt ist.

4. Magnetronsputtervorrichtung nach Anspruch 3, wobei ein Element (15) aus paramagnetischem Material so vorgesehen ist, dass es fortlaufend die außenseitige Fläche des fixierten äußeren Umfangsrahmenmagneten (4), gesehen von der Targetseite, und einem Teil der Fläche der Targetseite bedeckt.

5. Magnetronsputtervorrichtung nach Anspruch 3 oder 4, wobei der fixierte äußere Umfangsrahmenmagnet (4) eine Fläche aufweist, die zur Innenseite des Targets (1) vorsteht.

6. Magnetronsputtervorrichtung nach einem der Ansprüche 1 bis 5 mit ferner:
einem Abschirmelement (1901), das sich entfernt vom Target (1) befindet, um den Kantenteil des Targets (1) abzudecken und das auf der gegenüberliegenden Seite der wendelplattenartigen Magnetgruppe (3) angeordnet ist und elektrisch geerdet ist, wobei das Abschirmelement (1901) einen Schlitz (1903) aufweist, der sich in die selbe Richtung wie die Axialrichtung der säulenartigen Drehwelle (2) erstreckt und das Target relativ zu dem zu bearbeitenden Substrat frei legt.

7. Magnetronsputtervorrichtung nach Anspruch 1, wobei die rotierende Magnetgruppe (3) aus einer Anzahl von plattenartigen Magnetgruppen gebildet ist, wobei eine Anzahl von plattenartigen Magneten (3) an der säulenartigen Drehwelle (2) in einer Ringform angebracht sind,
wobei die plattenartigen Magnetgruppen, die aneinander in Axialrichtung der säulenartigen Drehwelle (2) angrenzen, durch die plattenartigen Magnetgruppen gebildet sind, die die N-Pole und die S-Pole mit gegenseitig unterschiedlichen Magnetpolen an der Außenseite in der Durchmesserrichtung der säulenartigen Drehwelle liefern,
wobei die Positionen in Axialrichtung jeder plattenartigen Magnetgruppe aufeinanderfolgen geändert sind mit derselben Verschiebung wie die Winkel in der Durchmesserrichtung der säulenartigen Drehwelle, die geändert werden.

8. Magnetronsputtervorrichtung nach Anspruch 7, wobei die plattenartigen Magnetgruppen (3) ausgebildet sind, um in die Axialrichtungsposition der angrenzenden plattenartigen Magnete (3) bewegt zu werden, wenn der Winkel in der Durchmesserrichtung der säulenartigen Drehwelle (2) um 180 Grad gedreht wird, und zu der original Axialrichtungsposition zurückgeführt werden, wenn der Winkel in der Durchmesserrichtung der säulenartigen Drehwelle (2) weiter um 180 Grad gedreht wird,
und wobei der fixierte äußere Umfangsrahmenmagnet (4) einen ersten plattenartigen Magneten aufweist, der in der Nähe einer Seite der rotierenden Magnetgruppe (3), gesehen von der Targetseite, platziert ist und der einen Magnetpol von entweder dem N-Pol oder dem S-Pol an der Targetflächenseite liefert, und einen plattenartigen Magneten, der einen Aufbau hat zum Umgeben der plattenartigen Magnetgruppe (3) und des ersten plattenartigen Magneten, gesehen von der Targetseite, und der den Magnetpol entgegengesetzt zu dem ersten plattenartigen Magneten auf der Targetseite aufweist.

9. Magnetronsputtervorrichtung nach Anspruch 6 oder 7, wobei die plattenartige Magnetgruppe (3) ausgebildet ist, um in der Axialrichtungsposition des angrenzenden plattenartigen Magneten (3) bewegt zu werden, wenn der Winkel in der Durchmesserrichtung der säulenartigen Drehwelle (2) um 180 Grad gedreht wird, und in die original Axialposition zurückgeführt zu werden, wenn der Winkel in der Durchmesserrichtung der säulenartigen Drehwelle (2) weiter um 180 Grad gedreht wird, wobei der fixierte äußere Umfangsrahmenmagnet (4) einen Aufbau aufweist zum Umgeben der rotierenden Magnetgruppe, gesehen von der Targetseite, und die Magnetpole der N-Pole oder der S-Pole an der Targetseite bildet.

10. Magnetronsputtervorrichtung nach einem der Ansprüche 1 bis 8, wobei zumindest ein Teil der säulenartigen Drehwelle (2) ein paramagnetisches Material ist.

11. Magnetronsputtervorrichtung nach einem der Ansprüche 1 bis 9, wobei ein fixiertes äußeres Umfangselement (15) aus paramagnetischem Material angrenzend an den fixierten äußeren Umfangsrahmenmagneten (4) auf der gegenüberliegenden Seite des fixierten äußeren Umfangsrahmenmagneten (4) relativ zum Target (1) ist.

12. Magnetronsputtervorrichtung nach einem der Ansprüche 1 bis 11, wobei die rotierende Magnetgruppe (3) und der fixierte äußere Umfangsrahmenmagnet (4) in einer Richtung rechtwinklig zu der Targetoberfläche bewegbar sind.

13. Magnetronsputtervorrichtung nach einem der Ansprüche 1 bis 12, wobei die rotierende Magnetgruppe (3) und der fixierte äußere Umfangsrahmenmagnet (4) innerhalb eines Raums angeordnet sind, der von einer Wandoberfläche umgeben ist, die nachfolgend von dem Targetelement (1) installiert ist, einer Trägerplatte (6), an dem das Targetelement (1) angebracht ist, und um die Trägerplatte (6), wobei der Raum in Druck reduziert werden kann.

14. Magnetronsputtervorrichtung nach einem der Ansprüche 1 bis 13, wobei das Substrat (10), das zu bearbeiten ist, in einer Richtung bewegbar ist, die die Axialrichtung der säulenartigen Drehwelle (2) schneidet.

15. Magnetronsputtersystem mit einer Anzahl von Magnetronsputtervorrichtungen nach einem der Ansprüche 1 bis 14, die parallel zu der Axialrichtung der Säulenartigen Drehwelle (2) angeordnet sind, wobei das zu bearbeitende Substrat (10) in einer Richtung, die sich mit der Axialrichtung der säulenartigen Drehwelle (2) schneidet, über die Anzahl von Magnetronsputtervorrichtungen bewegbar ist.

## Revendications

1. Appareillage de pulvérisation à magnétron qui comprend: un substrat à traiter (10); une cible (1) faisant face au substrat (10); et un aimant (3, 4) placé sur un côté opposé de la cible (1) relativement au substrat (10) dans lequel un plasma est confiné sur la surface de la cible par la génération d'un champ magnétique par l'aimant (3, 4) sur la surface de la cible;
dans lequel ledit aimant (3, 4) comprend un groupe d'aimants rotatif dans lequel une pluralité d'aimants en forme de plaque (3) est disposée autour d'un arbre de rotation colonnaire (2), et un aimant de cadre périphérique extérieur fixe (4) qui est disposé parallèlement à la surface de la cible autour du groupe d'aimants rotatif (3) et qui est magnétisé dans la direction perpendiculaire à la surface de la cible;
et dans lequel un modèle de champ magnétique sur ladite surface de la cible est déplacé le long d'une direction colonnaire dudit arbre de rotation colonnaire (2) par la rotation dudit groupe d'aimants rotatif (3),
dans lequel ledit groupe d'aimants rotatif (3) est configuré par l'installation d'une pluralité d'aimants en forme de plaque (3) à la circonférence extérieure dudit arbre de rotation colonnaire (2) de telle façon que les aimants en forme de plaques (3) adjacents l'un à l'autre dans la direction axiale dudit arbre de rotation colonnaire (2) ont des parties de pôles magnétiques différentes l'une de l'autre et les aimants en forme de plaque (3) adjacents l'un à l'autre ont différentes parties de pôles magnétiques sur une surface périphérique extérieure perpendiculaire à la direction axiale dudit arbre de rotation colonnaire (2);
et dans lequel ledit aimant de cadre périphérique extérieur fixe (4) a soit le pôle N ou le pôle S faisant face au côté cible et
dans lequel ledit groupe d'aimants rotatif (3) a les aimants en forme de plaque disposés selon une forme en spirale autour de l'arbre de rotation colonnaire (2) de façon à former une pluralité de spirales et les spirales adjacentes l'une à l'autre dans la direction axiale dudit arbre de rotation colonnaire (2) forment le pôle N et le pôle S qui sont des pôles magnétiques mutuellement différents du côté extérieur dans la direction diamétrale de l'arbre de rotation colonnaire (2);
et dans lequel ledit aimant de cadre périphérique extérieur fixe (4) a une configuration entourant ledit groupe d'aimants rotatif (3) lorsqu'on regarde depuis le côté cible et a soit le pôle N ou le pôle S faisant face au côté cible.

2. Appareillage de pulvérisation à magnétron suivant la revendication 1, dans lequel ledit groupe d'aimants rotatif (3) est configuré par l'installation en forme d'anneau d'une pluralité d'aimants en forme de plaque (3) à la circonférence extérieure dudit arbre de rotation colonnaire (2), et le placement d'une pluralité des anneaux dans la direction axiale dudit arbre de rotation colonnaire (2), et est configuré de telle façon que les anneaux adjacents l'un à l'autre dans la direction axiale dudit arbre de rotation colonnaire (2) ont des pôles magnétiques mutuellement différents, et la position dans la direction axiale dudit arbre de rotation colonnaire (2) des aimants en forme de plaque (3) de chaque anneau est changée lorsque l'angle dans la direction diamétrale dudit arbre de rotation colonnaire (2) est changée;
et dans lequel ledit aimant de cadre périphérique extérieur fixe (4) a une configuration entourant ledit groupe d'aimants rotatif (3) lorsqu'on regarde depuis le côté cible et a soit le pôle N ou le pôle S faisant face au côté cible.

3. Appareillage de pulvérisation à magnétron suivant l'une des revendications 1 ou 2, dans lequel:
le flux magnétique s'étendant vers l'extérieur de ladite cible (1) depuis ledit aimant de cadre périphérique extérieur fixe (4) est affaibli en comparaison avec le flux magnétique s'étendant vers le côté intérieur de ladite cible (1) depuis ledit aimant de cadre périphérique extérieur fixe (4).

4. Appareillage de pulvérisation à magnétron suivant la revendication 3, dans lequel un élément en matériau paramagnétique (15) est prévu de façon à couvrir consécutivement la surface extérieure dudit aimant de cadre périphérique extérieur fixe (4), lorsqu'on regarde depuis ledit côté cible et une partie de la face dudit côté cible.

5. Appareillage de pulvérisation à magnétron suivant la revendication 3 ou 4, dans lequel ledit aimant de cadre périphérique extérieur fixe (4) a sa surface en saillie vers le côté intérieur de la cible (1).

6. Appareillage de pulvérisation à magnétron suivant l'une des revendications 1 ou 5, comprenant en outre:
un élément de blindage (1901) qui est distant de ladite cible (1) de façon à couvrir la partie de bord de ladite cible (1) et qui est placé du côté opposé dudit groupe d'aimants en forme de plaque spiralée (3) et mis à la terre électriquement,
ledit élément de blindage (1901) ayant une fente (1903) qui s'étend dans la même direction que la direction axiale dudit arbre de rotation colonnaire (2) et qui expose le cible (1) relativement audit substrat à traiter.

7. Appareillage de pulvérisation à magnétron suivant la revendication 1, dans lequel ledit groupe d'aimants rotatif (3) est formé par une pluralité de groupes d'aimants en forme de plaque dans lequel une pluralité d'aimants en forme de plaque (3) sont attachés en forme d'anneau à l'arbre de rotation colonnaire (2),
lesdits groupes d'aimants en forme de plaque qui sont adjacents l'un à l'autre dans la direction axiale de l'arbre de rotation colonnaire (2) étant formés par les groupes d'aimants en forme de plaque qui fournissent le pôle N et pôle S comme pôles magnétiques mutuellement différents du côté extérieur dans la direction diamétrale dudit arbre de rotation colonnaire;
les positions dans la direction axiale de chaque groupe d'aimants en forme de plaque étant consécutivement changées avec le même déplacement que le changement des angles dans la direction diamétrale dudit arbre de rotation colonnaire (2).

8. Appareillage de pulvérisation à magnétron suivant la revendication 7, dans lequel lesdits groupes d'aimants en forme de plaque (3) sont formés de façon à se déplacer vers la position en direction axiale des aimants en forme de plaque adjacents (3) lorsque l'angle dans la direction diamétrale dudit arbre de rotation colonnaire (2) tourne de 180 degrés et à revenir à leur position d'origine en direction axiale lorsque l'angle dans la direction diamétrale dudit arbre de rotation colonnaire (2) tourne de 180 supplémentaires;
et dans lequel ledit aimant de cadre périphérique extérieur fixe (4) a un premier aimant en forme de plaque qui est placé à proximité d'un côté dudit groupe d'aimants rotatif (3) lorsqu'on regarde depuis ledit côté cible, et qui fournit un pôle magnétique qui est soit le pôle N ou le pôle S audit côté surface de la cible et un aimant en forme de plaque qui a une configuration entourant lesdits groupes d'aimants en forme de plaque (3) et ledit premier aimant en forme de plaque lorsqu'on regarde depuis le côté cible et qui a le pôle magnétique opposé à celui dudit premier aimant en forme de plaque sur ledit côté cible.

9. Appareillage de pulvérisation à magnétron suivant la revendication 6 ou 7, dans lequel ledit groupe d'aimants en forme de plaque (3) est formé de façon à se déplacer vers la position en direction axiale de l'aimant en forme de plaque adjacent (3) lorsque l'angle dans la direction diamétrale dudit arbre de rotation colonnaire (2) tourne de 180 degrés et à revenir à sa position d'origine en direction axiale lorsque l'angle dans la direction diamétrale dudit arbre de rotation colonnaire (2) tourne de 180 supplémentaires, ledit aimant de cadre périphérique extérieur fixe (4) ayant une configuration entourant ledit groupe d'aimants rotatif lorsqu'on regarde depuis ledit côté cible et formant le pôle magnétique du pôle N ou du pôle S audit côté cible.

10. Appareillage de pulvérisation à magnétron suivant l'une des revendications 1 à 8, dans lequel au moins une partie dudit arbre de rotation colonnaire (2) est dans un matériau paramagnétique.

11. Appareillage de pulvérisation à magnétron suivant l'une des revendications 1 à 9, dans lequel un élément périphérique extérieur fixe en matériau paramagnétique (15) est adjacent audit aimant de cadre périphérique extérieur fixe (4) du côté opposé dudit aimant de cadre périphérique extérieur fixe (4) relativement à la cible (1).

12. Appareillage de pulvérisation à magnétron suivant l'une des revendications 1 à 11, dans lequel ledit groupe d'aimants rotatif (3) et ledit aimant de cadre périphérique extérieur fixe (4) sont mobiles dans une direction perpendiculaire à la surface de la cible.

13. Appareillage de pulvérisation à magnétron suivant l'une des revendications 1 à 12, dans lequel ledit groupe d'aimants rotatif (3) et ledit aimant de cadre périphérique extérieur fixe (4) sont disposés à l'intérieur de l'espace entouré par une surface de paroi installée consécutivement depuis un élément cible (1), une plaque d'appui (6) à laquelle adhère l'élément cible (1) et autour de la plaque d'appui (6) et ledit espace peut être mis en dépression.

14. Appareillage de pulvérisation à magnétron suivant l'une des revendications 1 à 13, dans lequel ledit substrat (10) à traiter est mobile dans une direction intersectant la direction axiale dudit arbre de rotation colonnaire (2).

15. Système de pulvérisation à magnétron comprenant: une pluralité d'appareils de pulvérisation à magnétron suivant l'une des revendications 1 à 14 qui sont disposés parallèlement à la direction axiale dudit arbre de rotation colonnaire (2); dans lequel ledit substrat (10) à traiter est déplacé dans une direction intersectant la direction axiale dudit arbre de rotation colonnaire (2) sur ladite pluralité d'appareils de pulvérisation à magnétron.
